# FASCICULE DE BREVET EUROPEEN

(11) **EP 3 653 026 B1**
(45) Date de publication et mention de la délivrance du brevet: **25.02.2026**
(21) Numéro de dépôt: 18738345.0
(22) Date de dépôt: 13.07.2018
(51) Int. Cl.: H05K 3/38, H05K 3/12, H05K 3/34

(54) **CARTE ÉLECTRONIQUE COMPRENANT DES CMS BRASÉS SUR DES PLAGES DE BRASAGE ENTERRÉES**
ELEKTRONISCHE LEITERPLATTE MIT AUF VERGRABENEN LÖTPADS GELÖTETEN SMDS
ELECTRONIC BOARD COMPRISING SMDS SOLDERED ON BURIED SOLDER PADS

(30) Priorité: 13.07.2017 FR 1756697
(43) Date de publication de la demande: 20.05.2020
(73) Titulaire: Safran Electronics & Defense, 92100 Boulogne-Billancourt (FR)
(72) Inventeur: LECORDIER, Denis, 92100 Boulogne-Billancourt (FR); CHOCTEAU, Philippe, 92100 Boulogne-Billancourt (FR)
(74) Mandataire: Regimbeau
(86) Numéro de dépôt international: PCT/EP2018/069153
(87) Numéro de publication internationale: WO 2019/012139

(56) Documents cités:
- EP-A2- 1 261 028
- DE-A1- 4 243 356
- US-A- 5 498 575
- US-A1- 2002 084 314
- US-A1- 2002 187 585
- US-A1- 2014 158 414
- US-B1- 7 155 821

## Description

### DOMAINE DE L'INVENTION

L'invention concerne le domaine des cartes électroniques, notamment dans le domaine de l'aéronautique et spatial, et plus précisément la fixation de composants montés en surface sur des circuits imprimés.

### ARRIERE-PLAN TECHNOLOGIQUE

De manière connue en soi, une carte électronique peut comprendre des composants montés en surface (CMS), c'est-à-dire des composants électroniques brasés directement à la surface du circuit imprimé d'une carte électronique.

Habituellement, les CMS sont brasés en surface soit par refusion (« reflow soldering » en anglais), soit à la vague (« solder wave » en anglais).

Dans le cas du brasage par refusion, le circuit imprimé nu est tout d'abord sérigraphié en recouvrant les couches conductrices du circuit imprimés (généralement en cuivre) par une crème à braser à l'aide d'un écran de sérigraphie (ou pochoir) de sorte que seuls les emplacements destinés à recevoir les terminaisons des composants sont recouverts par la crème à braser. La crème à braser comprend, de manière connue en soi, un alliage métallique en suspension dans un flux de brasage. Puis les terminaisons des composants (CMS) sont posées sur la crème à braser avant de subir un traitement thermique de refusion, au cours duquel la chaleur fait refondre l'alliage et évaporer le flux de brasage de manière à former des joints de brasure à partir de l'alliage métallique présent dans la crème à braser.

La fiabilité et la durée de vie des joints de brasure, qui fixent les CMS au circuit imprimé, dépendent de la hauteur verticale (habituellement désignée par le terme anglais « standoff ») entre la face supérieure de la plage de brasage en cuivre et le point bas des terminaisons conductrices des CMS une fois brasés. Le standoff correspond donc à la hauteur d'alliage en interface entre le CMS et la couche de cuivre. En effet, en utilisation, le CMS et la surface sur laquelle il est brasé se dilatent différemment, provoquant des déplacements relatifs notamment dans le plan de la surface (X, Y). Ainsi, plus le standoff est grand, plus le joint de brasure est souple et donc robuste.

Toutefois, l'augmentation du standoff est limitée par les moyens usuels d'assemblage à disposition en production et par la diversité des géométries des boîtiers de composants à braser en surface.

Il a donc été proposé d'augmenter la quantité de crème à braser appliquée sur les couches du circuit imprimé. Pour cela, la taille (largeur) des orifices dans l'écran de sérigraphie peut par exemple être augmentée, de sorte que lors de l'étape de refusion, la hauteur du joint de brasure se trouve augmentée par effet de coalescence : l'épaisseur du joint de brasure est plus grande que l'épaisseur équivalente d'alliage obtenu après refusion avec des orifices plus petits dans l'écran de sérigraphie, puisque l'alliage métallique ne peut s'étaler au-delà des couches du circuit imprimé par effet de mouillabilité dans sa phase liquide (liquidus) durant la refusion. Cette méthode permet effectivement d'augmenter le standoff. Celui-ci reste cependant limité par le volume de crème à braser pouvant être introduit dans les orifices de l'écran pour des questions de démoulage et de limite de coalescence de la crème à braser sans générer de micro billes.

Par ailleurs, tous les composants d'une même carte électronique sont soumis à des paramètres de process communs, et notamment l'épaisseur du pochoir et le circuit imprimé de la carte. En effet, la hauteur de crème à braser déposée sur le circuit imprimé en vue de braser plusieurs CMS est sensiblement la même pour chaque CMS, puisque celle-ci est déposée par sérigraphie à l'aide d'un écran. De plus, le dépôt de la crème à braser par sérigraphie limite la densité d'implantation des composants électroniques sur le circuit imprimé et/ou le type de composant pouvant être utilisé, notamment dans le cas des composants à pas fin ou dans le cas des gros composants. Plus précisément, la taille des fenêtres de l'écran de sérigraphie est limitée par la condition suivante pour que l'écran puisse être démoulé sans endommager la crème à braser qui a été déposée : le rapport entre la surface de la fenêtre (dans le plan de l'écran, qui est parallèle au plan (X, Y)) et la surface des parois internes de la fenêtre (qui s'étendent perpendiculairement au plan de l'écran) doit être supérieur ou égal à 0.66. Pour respecter un tel rapport, lorsque le composant a un pas fin, il est donc nécessaire de réduire l'épaisseur de l'écran, ce qui implique nécessairement de diminuer la hauteur de crème à braser appliquée sur la face de connexion et/ou d'augmenter la surface de la fenêtre. A contrario, lorsque le composant est volumineux ou comprend terminaisons du type « pattes de mouette », pattes en J ou pattes en C, il est nécessaire d'augmenter la quantité de crème à braser dans l'orifice et donc de privilégier un pochoir ayant une épaisseur élevée. L'implantation à la fois de CMS à pas fin et de CMS de gros volume nécessite donc à la fois un pochoir de faible épaisseur et un pochoir d'épaisseur élevée.

Certes, il existe des écrans ayant une épaisseur variable afin d'augmenter localement la hauteur des orifices de l'écran, et donc la quantité de crème à braser déposée. Toutefois, ces épaisseurs variables impliquent souvent des problèmes de sérigraphie pour les CMS adjacents (hauteur de crème à braser dans les orifices adjacents insatisfaisante) et rend difficile l'optimisation de l'implantation des CMS dans la carte électronique. De plus, les épaisseurs minimales et maximales de l'écran qui peuvent être envisagées, tout en garantissant un remplissage suffisant des orifices restent insuffisantes pour garantir à la fois une durée de vie suffisante pour les composants de gros volume et la possibilité de braser des composants à pas fin sur la carte électronique.

Le document US 2014/158414 décrit un procédé et un dispositif comprenant un substrat multicouche comportant des composant électroniques placés en retrait du substrat.

### RESUME DE L'INVENTION

Un objectif de l'invention est donc de proposer un nouveau procédé de fixation de composants montés en surface sur un circuit imprimé qui permette d'augmenter la densité des composants, d'augmenter leur durée de vie, d'augmenter la mixité des composants électroniques en rendant possible l'assemblage sans contrainte, de composants variés, qu'il s'agisse de composants à pas fin, de grandes tailles, avec des pattes en ailes de mouette, etc., ce nouveau procédé étant en outre simple à réaliser et de coût modéré quelle que soit la densité d'implantation des composants sur le circuit imprimé et/ou le type de composant, sans pour autant impacter le rendement d'assemblage de la carte électronique.

Pour cela, l'invention propose un procédé de fabrication d'une carte électronique selon la revendication 1 et une carte électronique selon la revendication 14. Des modes de réalisation sont par ailleurs définis dans les revendications dépendantes.

Le procédé de fabrication comprend les étapes suivantes :
- former une première cavité dans la première couche conductrice de peau et dans la première couche isolante, en face de la plage de brasage de la première couche conductrice interne, de sorte qu'au moins une partie de la plage de brasage soit dévoilée,
- remplir la première cavité avec un alliage métallique accompagné d'un flux de brasage,
- placer un premier composant électronique en face de la première cavité,
- appliquer un traitement thermique au circuit imprimé sur lequel est placé le premier composant afin de transformer l'alliage métallique accompagné du flux de brasage en joint de brasure de manière à fixer le premier composant au circuit imprimé.

Certaines caractéristiques préférées mais non limitatives du procédé de fabrication décrit ci-dessus sont les suivantes, prises individuellement ou en combinaison :
- la première cavité est formée à l'aide de l'une au moins des techniques suivantes : photolithographie en surface, perçage laser, perçage mécanique, découpe mécanique.
- le procédé comprend en outre une étape de métallisation de la première cavité afin de déposer une couche métallique dans la première cavité.
- le procédé comprend en outre une étape supplémentaire dans laquelle une partie de la couche métallique de la première cavité est retirée préalablement à l'étape de remplissage de la première cavité.
- le retrait partiel de la couche métallique est réalisé par laser ou par découpe mécanique ou par perçage mécanique.
- la première couche conductrice interne comprend une plage de brasage supplémentaire et le procédé de fabrication comprend en outre les étapes supplémentaires suivantes, préalablement à l'étape de traitement thermique : former une deuxième cavité dans la première couche isolante, en face de la plage de brasage supplémentaire, de sorte qu'au moins une partie supplémentaire de la plage de brasage supplémentaire soit dévoilée ; remplir la deuxième cavité avec l'alliage métallique accompagné d'un flux de brasage ; et placer un deuxième composant électronique en face de la deuxième cavité, les étapes de remplissage des première et deuxième cavités et de placement des composants étant réalisées sensiblement simultanément.
- le procédé comprend en outre une étape de gravure de la première couche conductrice de peau.
- la première cavité est remplie conformément à l'une au moins des techniques de remplissage suivantes : sérigraphie avec écran de sérigraphie, sérigraphie sans écran de sérigraphie, impression jet d'encre, passage dans une vague turbulente, par trempage ou passage au travers d'un bain d'alliage métallique en refusion, brasage à la vague, brasage manuel.
- la deuxième couche conductrice interne est traitée de manière à former au moins une plage de brasage, le procédé de fabrication comprenant en outre les étapes suivantes, préalablement à l'étape de traitement thermique : former une troisième cavité dans la première couche isolante et dans la troisième couche isolante, en face de la plage de brasage de la deuxième couche conductrice interne, de sorte qu'au moins une partie de la plage de brasage de la deuxième couche conductrice interne soit dévoilée ; remplir la troisième cavité avec l'alliage métallique accompagné d'un flux de brasage ; et placer un troisième composant électronique additionnel en face de la troisième cavité.
- la deuxième couche conductrice interne est traitée de manière à former au moins une plage de brasage, le procédé de fabrication comprenant en outre les étapes suivantes, préalablement à l'étape de traitement thermique : former une quatrième cavité dans la deuxième couche conductrice de peau et dans la deuxième couche isolante, en face de la plage de brasage de la deuxième couche conductrice interne, de sorte qu'au moins une partie de la plage de brasage de la deuxième couche conductrice interne soit dévoilée ; remplir la quatrième cavité avec l'alliage métallique accompagné d'un flux de brasage ; et placer un quatrième composant électronique en face de la quatrième cavité.
- le procédé comprend en outre, préalablement à l'étape de traitement thermique, une étape au cours de laquelle une couche additionnelle comprenant un matériau isolant électriquement est appliquée sur la première couche conductrice de peau, la première cavité étant formée en partie dans ladite couche additionnelle.
- le matériau électriquement isolant de la couche additionnelle présente un premier coefficient de dilatation thermique suivant l'axe Z, l'alliage métallique présente un deuxième coefficient de dilatation thermique suivant l'axe Z, et dans lequel le premier coefficient de dilatation thermique est plus grand que le deuxième coefficient de dilatation thermique.
- une surface de la première cavité, dans le plan, est au moins égale à 0.04 mm².

La carte électronique comprend un circuit imprimé multicouche, ledit circuit imprimé comprenant au moins quatre couches conductrices séparées deux à deux par des couches isolantes, dont :
- une première et une deuxième couche conductrices de peau fixées sur une première et une deuxième couche isolante, respectivement, la première couche conductrice étant sensiblement plane et définissant un plan normal à un axe Z,
- une première et une deuxième couches conductrices internes, s'étendant entre la première et la deuxième couche isolante, respectivement, et séparées par une troisième couche isolante, au moins la première couche conductrice interne étant traitée de manière à former au moins une plage de brasage,
- une première cavité, formée dans la première couche conductrice de peau et dans la première couche isolante, ladite première cavité dévoilant au moins en partie la plage de brasage, et
- un premier composant électronique monté en surface comprenant au moins une terminaison, ledit premier composant étant en contact ou à distance de la première couche conductrice de peau, la terminaison du premier composant étant fixée dans la première cavité par l'intermédiaire d'un joint de brasure.

Certaines caractéristiques préférées mais non limitatives de la carte électronique décrite ci-dessus sont les suivantes, prises individuellement ou en combinaison :
- la première cavité comprend une couche métallique de métallisation.
- la première cavité est recouverte partiellement d'une couche métallique de métallisation.
- la carte électronique comprend en outre un vernis épargne appliqué sur la première couche conductrice et sur le dessus de la couche isolante au moins partiellement dévoilée et/ou une finition métallique appliquée sur la première couche conductrice de peau et les zones de la première couche conductrice interne qui forment la première cavité.
- le premier composant comprend une terminaison supplémentaire, ladite terminaison étant fixée sur la première couche conductrice de peau par l'intermédiaire d'un joint de brasure.
- la deuxième couche conductrice interne est traitée de manière à former au moins une plage de brasage, la carte électronique comprenant en outre : une deuxième cavité, formée dans la première couche isolante et dans la troisième couche isolante, en face de la deuxième couche conductrice interne, et un deuxième composant électronique monté en surface comprenant au moins une terminaison, ledit deuxième composant étant en contact ou à distance de la première couche conductrice de peau, la terminaison du deuxième composant étant fixée dans la deuxième cavité par l'intermédiaire d'un joint de brasure.
- le premier composant comprend en outre une terminaison supplémentaire, la deuxième couche conductrice interne est traitée de manière à former au moins une plage de brasage et la carte électronique comprend en outre une cavité supplémentaire, formée dans la première couche isolante et dans la troisième couche isolante, en face de la plage de brasage de la deuxième couche conductrice interne, la terminaison supplémentaire du composant étant fixée sur ladite plage de brasage dans la cavité supplémentaire par l'intermédiaire d'un joint de brasure.
- la deuxième couche conductrice interne est traitée de manière à former au moins une plage de brasage, la carte électronique comprenant en outre : une quatrième cavité, formée dans la deuxième couche conductrice de peau et dans la deuxième couche isolante, en face de la deuxième couche conductrice interne, et un quatrième composant électronique monté en surface comprenant au moins une terminaison, ledit quatrième composant étant en contact ou à distance de la deuxième couche conductrice de peau, la terminaison du quatrième composant étant fixée dans la quatrième cavité par l'intermédiaire d'un joint de brasure.
- une surface de la première cavité, dans le plan, est au moins égale à 0.04 mm².

### BREVE DESCRIPTION DES DESSINS

D'autres caractéristiques, buts et avantages de la présente invention apparaîtront mieux à la lecture de la description détaillée qui va suivre, et au regard des dessins annexés donnés à titre d'exemples non limitatifs et sur lesquels :
Les figures 1a à 1l illustrent des étapes d'un exemple de réalisation d'un procédé de fixation conforme à l'invention.
Les figures 2a à 2c sont des vues en coupe partielle de trois exemples de réalisation de cartes électroniques comprenant des cavités partiellement ou totalement métallisées dans lesquelles est brasé un exemple de composant,
La figure 3a est une vue en coupe d'un autre exemple de réalisation de métallisation partielle de cavités, à des profondeurs différentes, tandis que la figure 3b est une vue de deux exemples de réalisation de la cavité de gauche de l'exemple de la figure 3a avant remplissage,
La figure 4a est une vue en coupe d'un autre exemple de réalisation de métallisation partielle de cavités, à des profondeurs différentes, tandis que la figure 4b est une vue du dessus de la cavité de l'exemple de la figure 4a avant remplissage,
Les figures 5 à 8 sont des exemples de cartes électroniques conformes à l'invention, et

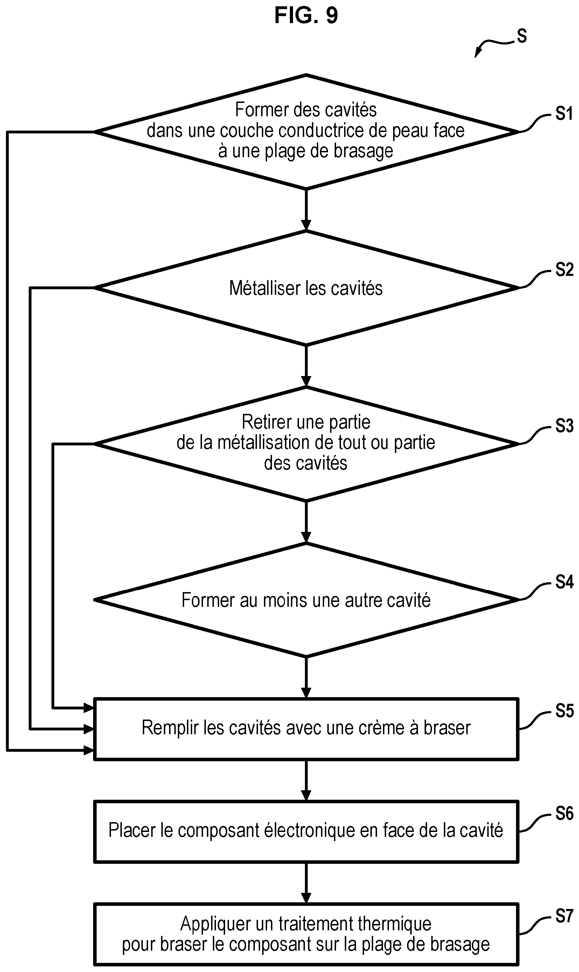

La figure 9 est un organigramme illustrant un exemple des étapes de fabrication d'une carte électronique conforme à un mode de réalisation de l'invention.

### DESCRIPTION DETAILLEE D'UN MODE DE REALISATION

Une carte électronique 1 comprend un circuit imprimé 2 comportant des couches conductrices séparées par des couches isolantes 10, 11, 12, sur lequel sont fixés des composants électroniques montés en surface (ci-après CMS 3).

De manière générale, un circuit imprimé 2 peut être du type monocouche (également appelé simple couche) et ne comprendre qu'une seule couche conductrice, double couche (également appelé double face) et comprendre une couche conductrice de part et d'autre d'une couche isolante ou multicouche et comprendre au moins quatre couches conductrices.

La présente invention présente un intérêt tout particulier lorsque le circuit imprimé 2 est un multicouche et comprend au moins quatre couches conductrices, séparées deux à deux par des couches isolantes 10, 11, 12. Dans ce qui suit, l'invention va plus particulièrement être décrite dans le cas d'un circuit imprimé 2 comprenant exactement quatre couches conductrices, dont :
- une première et une deuxième couches conductrices de peau (ci-après couche C₁ et couche C₂, respectivement) fixées sur une première et une deuxième couche isolante 10 et 11, respectivement,
- une première et une deuxième couches conductrices internes (ci-après couche C₃ et couche C₄, respectivement), s'étendant entre la première et la deuxième couche isolante 10 et 11, respectivement, et séparées par une troisième couche isolante 12.

Ceci n'est cependant pas limitatif dans la mesure où, comme nous le verrons par la suite, l'invention s'applique également dans le cas où le circuit imprimé 2 comprend un plus grand nombre de couches conductrices interne (par exemple des couches C₅ et C₆) séparées deux à deux par des couches isolantes 10, 11, 12 supplémentaires.

La couche C₁ est sensiblement plane et définit un plan (X ; Y) normal à un axe Z. Les couches C₁ et C₂ correspondent aux couches du circuit imprimés 2 situées le plus à l'extérieur dudit circuit et sandwichent les couches isolantes 10, 11, 12 et les couches conductrices internes C₃ et C₄.

Afin d'augmenter la mixité de la carte électronique 1 et d'améliorer la durée de vie des composants, la carte électronique 1 peut être fabriquée conformément aux étapes suivantes :
- former S1 une cavité 20 dans la couche C₁ (respectivement, dans la couche C₂) et dans la première couche isolante 10 (respectivement, dans la deuxième couche isolante 11), en face d'une plage de brasage 4 de la couche C₃ ou de la couche C₄, de sorte qu'au moins une partie de la plage de brasage 4 soit dévoilée,
- remplir S5 la cavité 20 avec un alliage métallique accompagné d'un flux de brasage,
- placer S6 une terminaison 8 du CMS 3 sur la couche C₁ (respectivement, sur la couche C₂) en face de la cavité 20,
- appliquer un traitement thermique S7 au circuit imprimé 2 sur lequel est placé le CMS afin de transformer l'alliage métallique accompagné du flux de brasage en joint de brasure 5 de manière à fixer le CMS 3 au circuit imprimé 2.

Une surface des cavités, dans le plan (X ; Y), est au moins égale à 0.04 mm² afin d'atteindre la durée de vie souhaitée pour le CMS 3.

Une profondeur p de la cavité 20 peut par exemple être au moins égale à 60 µm. Par exemple, pour une cavité 20 présentant une profondeur p de 60 µm, la durée de vie est augmentée de 50%. Pour une cavité 20 présentant une profondeur p de 120 µm, la durée de vie est augmentée de 100%.

Comme indiqué plus haut, la cavité 20 peut être formée (étape S1) de manière à dévoiler une plage de brasage 4 de la couche C₃ ou une plage de brasage 4 de la couche C₄. Seule la profondeur p de la cavité 20 et le nombre de couches isolantes 10, 11, 12 traversées change, les étapes du procédé S n'étant pas modifiées.

Par ailleurs, la cavité 20 peut être formée depuis la couche C₁ ou depuis la couche C₂. Une ou plusieurs cavités 20 peuvent d'ailleurs être formées à la fois depuis la couche C₁ et depuis la couche C_{2.}

Enfin, plusieurs cavités 20 peuvent être formées dans le circuit imprimé 2. Ces cavités 20 peuvent présenter des profondeurs p différentes et donc atteindre une plage de brasage 4 de la couche C₃ ou de la couche C₄.

Le nombre de cavités 20, leur profondeur p (et donc la couche conductrice interne C₃ ou C₄ atteinte) et la couche C₁ ou C₂ depuis laquelle sont formées les cavités 20 dépendent du type de CMS 3 fixé sur le circuit imprimé 2, mais également la mixité et de la densité à atteindre pour le circuit imprimé 2.

Dans ce qui suit, afin de simplifier la description l'invention va plus particulièrement être décrite dans le cas où quatre cavités 20 sont formées dans le circuit imprimé 2, dont deux cavités 20 depuis la couche C₁, en face de deux plages de brasage 4 de la couche C₃, et deux cavités 20 depuis la couche C₂, en face de deux plages de brasage 4 de la couche C₄. Ceci n'est cependant pas limitatif, comme nous l'avons vu plus haut, un nombre différent de cavités 20 pouvant être formé dans le circuit imprimé 2, depuis la couche C₁ et/ou depuis la couche C₂, chacune desdites cavités 20 pouvant traverser un nombre de couche isolantes supérieur ou égal à un.

L'ordre décrit ci-dessus pour les étapes de placement du CMS 3 et de remplissage de la cavité 20 n'est par ailleurs pas limitatif. Le CMS 3 peut être posé au-dessus de la cavité 20 (étape S6) avant ou après que celle-ci ne soit remplie (étape S5), selon la technique de remplissage choisie. En effet, l'étape S5 de remplissage peut être réalisée en remplissant la cavité 20 avec une crème à braser comprenant un alliage métallique en suspension dans un flux de brasage. Dans ce cas, le CMS 3 est posé sur la crème à braser (étape S6), au-dessus de la cavité 20. En variante, l'étape S5 de remplissage de la cavité 20 peut être réalisée par un apport au travers d'un bain d'alliage en fusion, auquel cas le CMS 3 est posé sur un point de colle sur la couche C₁ (étape S6) avant le passage du circuit imprimé 2 dans le bain d'alliage en fusion.

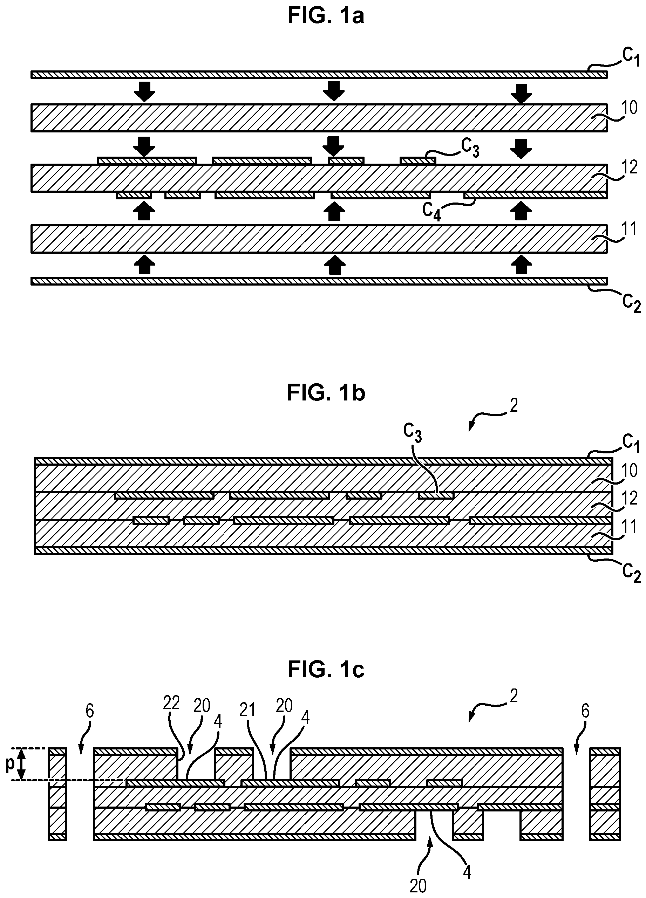

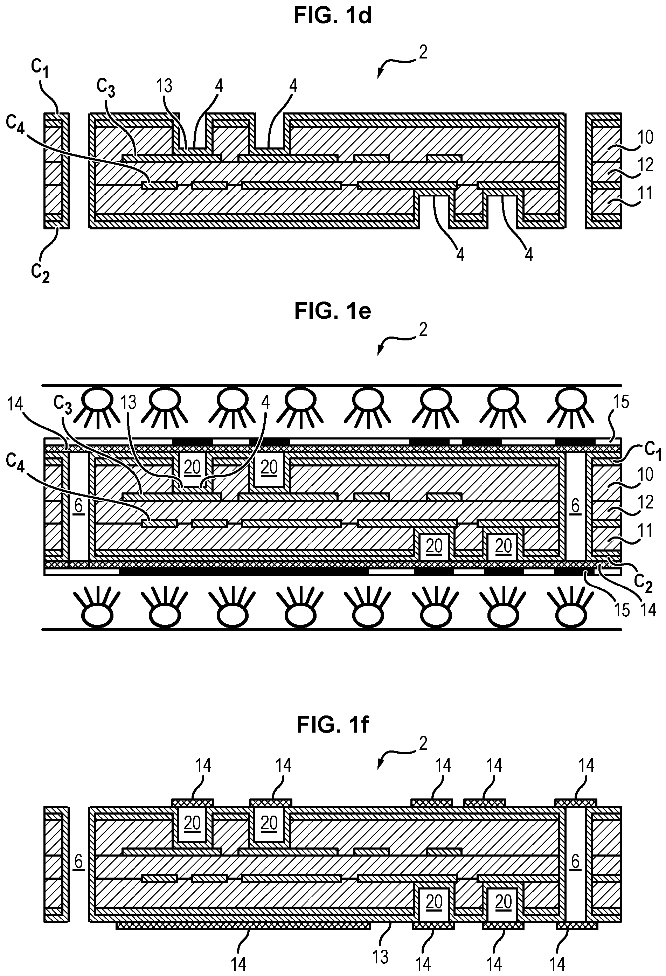

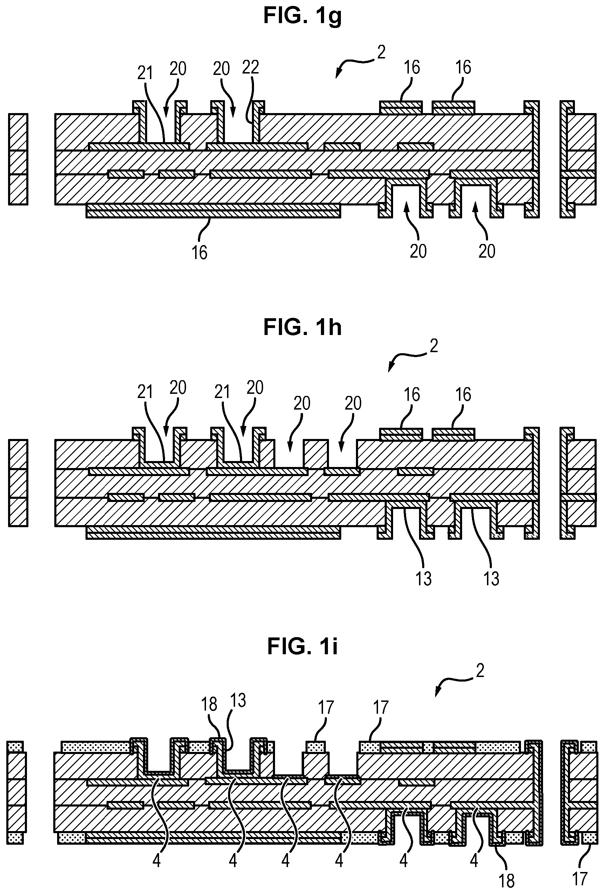

La plage de brasage 4 de la couche C₃ peut être obtenue, de manière connue en soi, par traitement chimique de la couche C₃, typiquement par gravure. Cette étape de traitement chimique peut notamment être mise en œuvre lors de la fabrication du circuit imprimé 2, préalablement à l'étape d'empilage des couches conductrices C₁ et C₂ et des couches isolantes 10, 11, 12 destinées à former le circuit imprimé 2. Par exemple, le circuit multicouche peut être obtenu conformément aux sous-étapes suivantes (voir Figure 1a) :
- fournir un circuit imprimé 2 double face, c'est-à-dire comprenant une couche isolante (destinée à devenir la troisième couche isolante 12) et deux couches conductrices (destinées à devenir les couches C₃ et C₄) de part et d'autre de la couche isolante,
- graver au moins l'une des couches C₃ et C₄, de préférence les deux, afin de former des plages de brasage 4 dans les couches C₃ et C₄,
- rapporter et fixer une autre couche isolante sur chaque couche C₃ et C₄, lesdites couches isolantes étant destinées à devenir respectivement la première et la deuxième couche isolante 10, 11 du circuit multicouche,
- rapporter et fixer une couche conductrice sur chacune des couches isolantes 11, 12 additionnelles, lesdites couches conductrices étant destinées à devenir les couches C₁ et C₂, et
- comprimer en température l'ensemble ainsi formé afin d'obtenir le circuit imprimé 2 multicouche. On obtient alors le circuit imprimé 2 de la figure 1b.

En variante, le circuit multicouche peut être approvisionné directement 2.

Le cas échéant, les couches C₁ et C₂ peuvent également être gravées, préalablement ou après la sous-étape de compression en température, afin de former des plages de brasage 4 et/ou des pistes conductrices.

Les couches isolantes 10, 11, 12 du circuit imprimé 2 peuvent comprendre, de manière connue en soi, une résine epoxy et des fibres de verre. Les couches conductrices C₁ à C₄ quant à elles peuvent être en cuivre (ou dans un alliage à base de cuivre).

Les cavités 20 peuvent être formées par découpe de la couche C₁ et de la première couche isolante 10. La découpe peut être effectuée mécaniquement (à l'aide d'un outil de découpe de type fraisage mécanique ou perçage mécanique ou perçage laser). La réalisation par perçage laser ne pourra être réalisable qu'à partir du moment où la surface (dans le plan (X, Y)) au fond 21 d'une cavité 20 est plus petite que la plage de brasage 4 en cuivre de sorte que la plage de brasage 4 s'étende au-delà du fond 21 de la cavité 20 pour permettre l'arrêt de l'action du laser C0₂ en profondeur p sur le cuivre.

Lorsque les cavités 20 sont réalisées par perçage laser, le laser peut être du type laser au gaz (dioxyde de carbone). Les paramètres choisis pour le laser peuvent alors être similaires à ceux utilisés habituellement pour la réalisation de vias laser.

La technique du perçage laser permet de former des cavités 20 avec une grande précision. En particulier, il est possible de positionner des cavités 20 avec une grande précision et de faibles tolérances dimensionnelles. Typiquement, la tolérance dimensionnelle est de l'ordre de 25 microns (pour des cavités 20 de 100 µm minimum de côté) lorsque les cavités 20 sont réalisées par perçage laser, par opposition à environ 100 microns (pour des cavités 20 de 300 µm minimum de côté) lorsqu'elles sont réalisées par découpe (mécanique ou chimique).

Le perçage laser permet ainsi une augmentation de la densité des CMS 3 sur le circuit imprimé 2, puisque la dimension des cavités 20 peut être réduite (la taille minimum de la cavité pouvant être obtenue par perçage laser étant plus petite).

Le perçage laser permet ainsi une augmentation de la densité des CMS 3 sur le circuit imprimé 2, puisque la distance entre deux cavités 20 peut être réduite (les tolérances de positionnement et dimensionnelles étant plus petites).

La forme des cavités 20 est de préférence cylindrique, notamment lorsqu'elles sont obtenues par perçage laser, par découpe mécanique ou par perçage mécanique. La section dans le plan (X, Y) des cavités 20 peut être quelconque, par exemple circulaire, rectangulaire, etc.

Le cas échéant, un ou plusieurs vias traversants 6 peuvent également être réalisés dans le circuit imprimé 2 suivant les techniques conventionnelles.

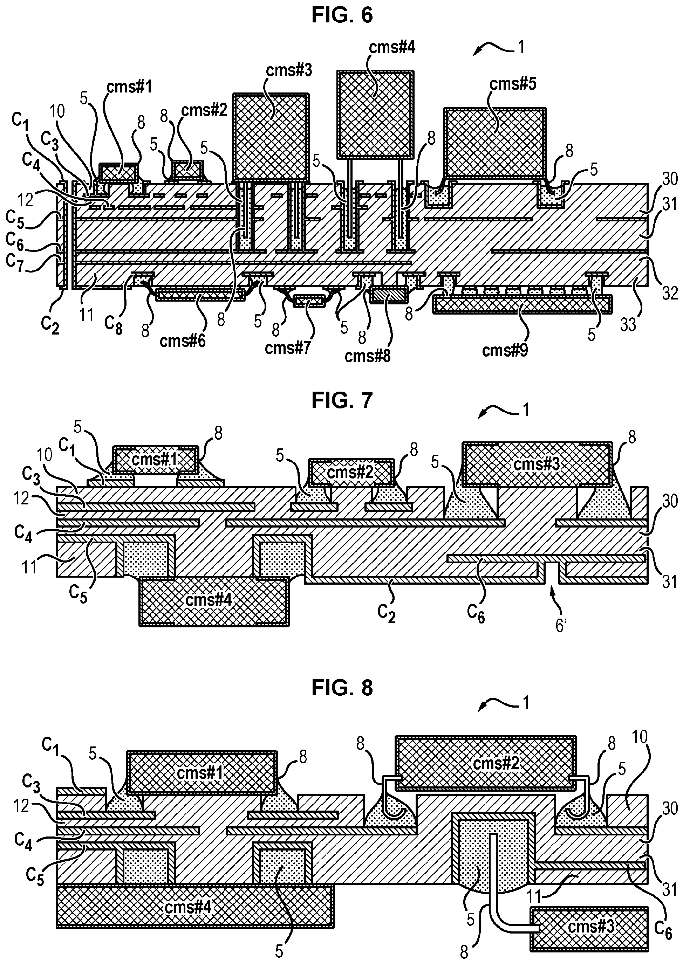

Le cas échéant, un ou plusieurs vias lasers 6' peuvent également être réalisés dans le circuit imprimé 2 suivant les techniques conventionnelles (voir notamment figure 7).

Dans une première variante de réalisation illustrée sur la figure 1d, les cavités 20 peuvent être métallisées (étape S2) avant leur remplissage S5 avec un alliage métallique accompagné d'un flux de brasage. La métallisation S2 a pour effet de déposer une fine couche métallique 13 (d'une épaisseur de quelques micromètres) sur les parois de chaque cavité 20.

Les couches C₁ et C₂ et les plages de brasage 4 étant généralement en cuivre, la couche métallique 13 déposée est une couche de cuivre dont l'épaisseur peut être de l'ordre d'une vingtaine de micromètres.

La métallisation des cavités 20 peut être effectuée par toute technique conventionnelle, par exemple par électrolyse. La couche de cuivre 13 peut comprendre une première couche de cuivre dite « chimique » suivi d'une dépose d'une seconde de cuivre dite « électrolytique » et recouvre le fond 21 des cavités 20 (correspondant sensiblement à la plage de brasage 4) et les surfaces dévoilées de la première et de la deuxième couche isolante 10, 11 (qui forment les parois verticales 22 des cavités 20).

Dans une forme de réalisation, à la fois les couches C₁, C₂ et les cavités 20 sont métallisées lors de cette étape. Les couches C₁, C₂, les plages de brasage 4 et les parois verticales 22 des cavités 20 sont recouvertes d'une couche de cuivre 13, résultat de la dépose d'un cuivre chimique suivi d'un dépôt de cuivre électrolytique.

Le procédé S peut en outre comprendre une étape de gravure de la couche C₁ (figure 1e). Pour cela, de manière connue en soi, un film photosensible 14 est appliqué sur la face libre des couches C₁ et C₂. Le film photosensible 14 est de préférence une résine positive (le rayonnement ultraviolet entraîne une rupture des macromolécules, d'où une solubilité accrue des zones exposées dans le solvant de révélation). La résine peut notamment comprendre une résine époxy.

Un masque 15 (ou typon) est ensuite appliqué sur le film photosensible 14. Le masque 15 comprend des zones transparentes et des zones opaques afin de permettre la gravure de la couche C₁ et former, par exemple, des pistes conductrices 16 et/ou une collerette 23 à la sortie d'une ou de plusieurs cavités 20. Dans l'exemple illustré sur la figure 1e, le typon 15 comprend par exemple des zones opaques au niveau de deux cavités 20, du via 6 et de deux zones destinées à former des pistes conductrices 16.

Enfin, le film photosensible 14 est exposé à une radiation lumineuse : dans le cas d'une résine positive (typiquement la résine époxy), les parties du film 14 présentes sous les zones transparentes vont alors réagir à cette radiation lumineuse et se solubiliser, tandis que les parties présentes sous les zones opaques en seront protégées. En variante, le typon 15 est insolé par procédé laser (généralement connu sous sa terminologie anglaise de Laser Direct Insolation LDI).

Dans tous les cas, les parties solubilisées sont ensuite éliminées à l'aide d'un solvant de révélation, ce qui permet de découvrir en partie la couche C₁. Les parties non solubilisées du film photosensible 14 restent au-dessus des deux cavités 20, du via 6 et des deux zones destinées à former des pistes conductrices 16.

Les zones non protégées par le film photosensible 14 peuvent alors être gravées jusqu'à disparition totale du cuivre, par exemple par électrolyse (figure 1g).

Ce procédé S de gravure étant connu en soi, il ne sera pas détaillé davantage ici.

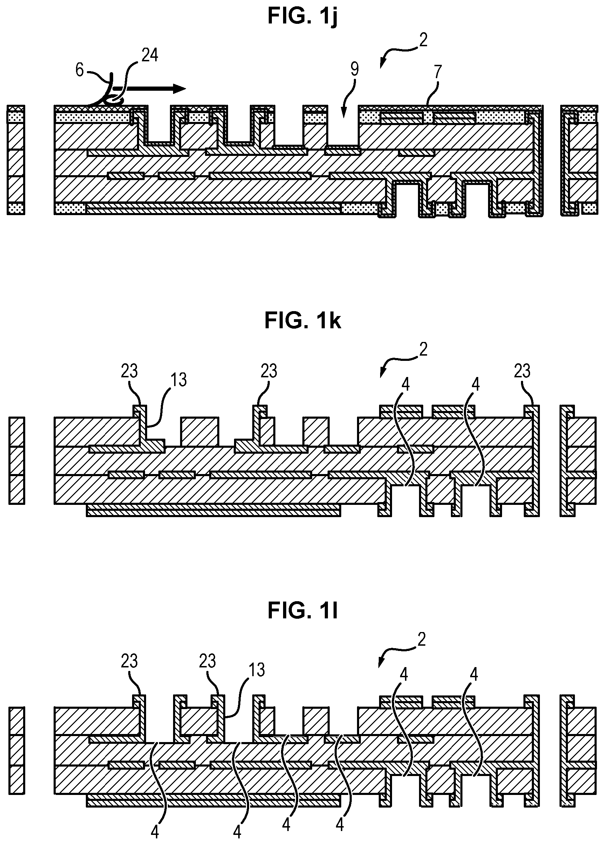

De manière optionnelle, une partie de la métallisation peut être retirée (étape S3), de manière à obtenir un ou plusieurs cavités 20 partiellement métallisées (figures 1k et 1l). Ce retrait S3 peut être effectué au niveau de toutes les cavités 20 formées dans les couches C₁ et C₂, au niveau d'une partie seulement des cavités 20 formées dans les couches C₁ et C₂, ou encore différemment selon les cavités 20 formées dans les couches C₁ et C₂, afin d'adapter la métallisation de chaque cavité 20 au type de terminaison 8 destinée à être fixée dans lesdites cavités 20. Le retrait partiel peut également concerner les couches C₁ et C₂, en tout ou partie, afin de former une ou plusieurs collerettes 23 (complètes ou partielles).

Ce retrait peut notamment être réalisé par laser, afin de percer la couche de cuivre chimique. Le retrait partiel S3 peut concerner :
- tout ou partie de la couche métallique 13 déposée sur les parois verticales 22 d'une ou de plusieurs cavités 20 et/ou
- tout ou partie tout ou partie de la couche métallique 13 déposée au fond 21 d'une ou de plusieurs cavités 20 et/ou
- tout ou partie de la couche métallique 13 déposée sur les couches C₁ et/ou C₂.

Le cas échéant, le laser peut être incliné par rapport aux parois verticales 22 de la cavité 20 afin de présenter un angle de frappe non nul pour mieux retirer la métallisation des parois verticales 22.

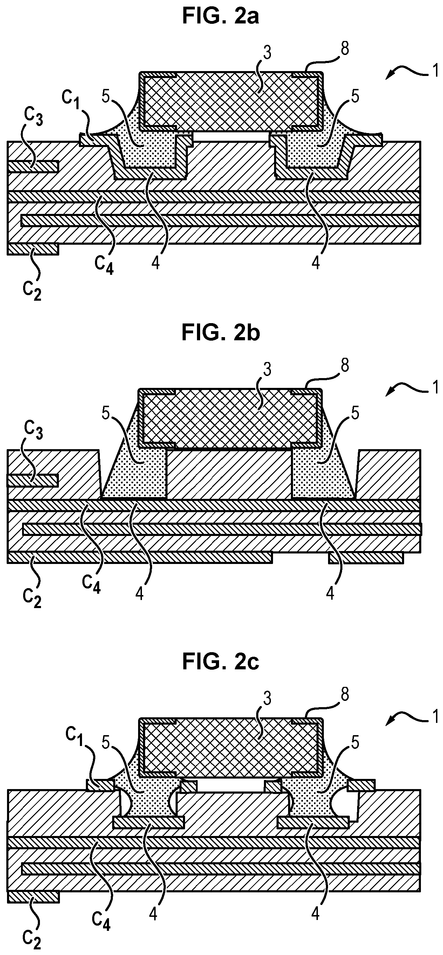

Par exemple, on a illustré sur la figure 2a un exemple d'une partie d'une carte électronique 1, dans lequel la cavité 20 a été métallisée mais où la couche métallique 13 n'a pas été retirée.

On a par ailleurs illustré sur la figure 2b le cas où la couche métallique 13 a été retirée sur toute la paroi verticale 22 des cavités 20 et à la sortie des cavités 20, mais a été laissée au fond 21 de la cavité 20.

La figure 2c illustre le cas où la couche métallique 13 a été retirée sur toute la paroi verticale 22 des cavités 20 mais a été laissée au fond 21 de la cavité 20 et à la sortie de la cavité 20, formant ainsi deux collerettes 23 dans la couche C₁.

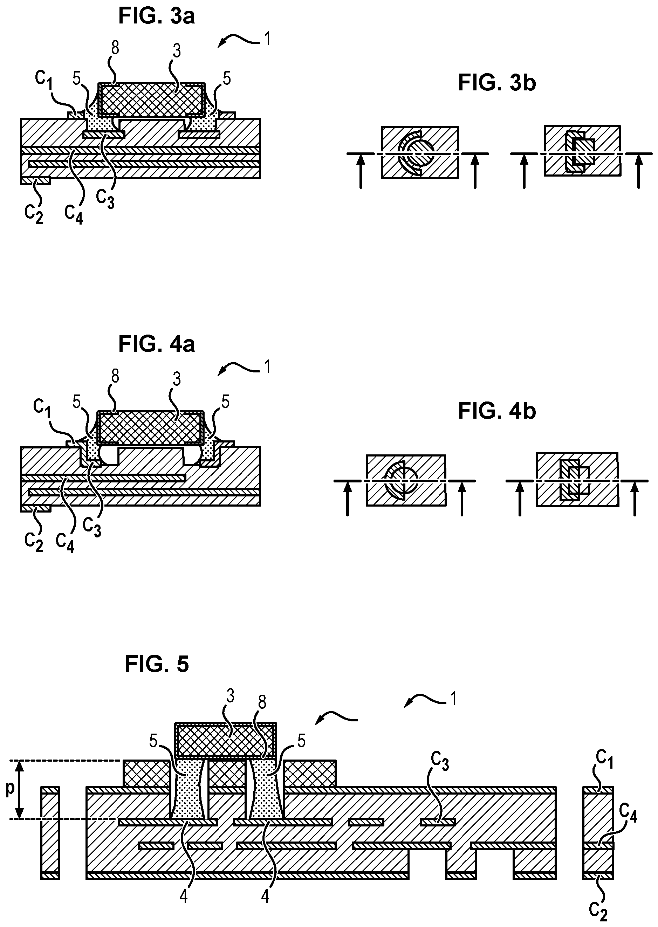

Les figures 3a et 3b illustrent le cas où la couche métallique 13 a été retirée sur une toute la paroi verticale 22 des cavités 20 mais a été laissée au fond 21 de la cavité 20 et sur une partie de la sortie des cavités 20, formant ainsi deux demi-collerettes 23 dans la couche C₁.

Les figures 4a et 4b illustrent le cas où la couche métallique 13 a été retirée sur une moitié de la périphérie de la paroi verticale 22 des cavités 20, sur une moitié du fond 21 de la cavité 20 et sur une partie de la sortie des cavités 20 pour former deux demi-collerettes 23 dans la couche C₁.

On comprendra que l'étape S3 de retrait partiel de la couche métallique 13 peut être effectuée avant ou après l'étape de gravure de la couche C₁.

Le cas échéant, une ou plusieurs cavités 20 non métallisées peuvent également être réalisées dans la couche C₁ (étape S4) après l'étape S2 de métallisation, par perçage laser de la couche C₁ et de la première couche isolante 10.

En variante, les cavités 20 non métallisées peuvent être obtenues, comme indiqué plus haut, en retirant la couche de cuivre de la cavité 20 déjà formée (pendant l'étape S3).

De manière conventionnelle, une couche de vernis épargne 17 peut ensuite être appliquée sur les surfaces dévoilées de la première couche isolante 10 et, le cas échéant, sur les pistes conductrices 16, sans recouvrir les parties nécessitant un contact électrique avec l'extérieur (telles que les parois verticales 22 des cavités 20, leur éventuelle collerette 23 ou encore un contact de reprise de masse par exemple).

Une finition 18 peut également être déposée afin de protéger le cuivre qui reste exposé et de maintenir la capacité des plages 4 à recevoir un joint de brasure 5. La finition 18 peut comprendre, de manière connue en soi, une finition organique (Organic Solder Preservative, OSP) ou une finition métallique comprenant l'un au moins des alliages suivants : nickel/or chimique, nickel/or galvanique, étain chimique, argent chimique. L'épaisseur de la finition 18 peut être de l'ordre de quelques microns et peut être appliquées sur toutes les surfaces exposées en cuivre.

Le cas échéant, une finition 18 par nivelage à air chaud (Hot Air Levelling, HAL) à base d'alliage du type plomb/étain ou étain peut être utilisée.

Les cavités 20 peuvent être remplies par sérigraphie d'une crème à braser 24 comprenant l'alliage métallique en suspension dans le flux de brasage.

Pour cela, au cours d'une première sous-étape, un écran 7 de sérigraphie (ou pochoir) dans lequel ont été formées deux fenêtres 9 (une par cavité 20 formées) est placé sur la couche C₁. L'écran 7 est positionné de sorte que chaque fenêtre se trouve en regard de la cavité 20 correspondante à remplir.

Bien entendu, l'écran 7 peut comprendre un nombre différent de fenêtres 9 si un nombre différent de cavités 20 doit être rempli.

Les dimensions des fenêtres 9 sont sensiblement égales aux dimensions de la cavité 20 associée à remplir afin d'optimiser le remplissage de la cavité 20. De préférence la précision dimensionnelle pour la réalisation des fenêtres 9 est de l'ordre de trente micromètres. Les fenêtres 9 peuvent être légèrement plus grandes que la cavité 20 associée afin d'assurer un bon remplissage de celles-ci et d'augmenter la quantité de crème à braser 24 déposée.

Au cours d'une deuxième sous-étape, de la crème à braser 24 est déposée sur l'écran 7 puis forcée dans les fenêtres 9 et dans les cavités 20 à l'aide d'une raclette (voir figure 1j). De manière connue en soi, la raclette peut comprendre une tôle métallique, qui est inclinée suivant un angle pouvant être compris entre 45° et 60° afin de mieux pousser la crème à braser 24 dans la cavité 20.

Au cours d'une troisième sous-étape, l'écran 7 peut être démoulé de manière à laisser la crème à braser 24 dans les cavités 20. On notera que l'épaisseur de la crème à braser 24 déposée étant plus grande que l'épaisseur de la couche C₁ et de la première couche isolante 10, en raison de la présence de l'écran 7 lors du remplissage.

Un CMS 3 peut alors être posé sur la couche C₁, de sorte que chaque terminaison 8 se trouve au-dessus d'une cavité (étape S 6), puis le traitement thermique S7 peut être appliqué à la carte électronique 1.

Les trois sous-étapes décrites ci-dessus pour le remplissage des cavités 20 par sérigraphies sont ensuite répétées pour les cavités 20 de la couche C₂.

Dans une variante de réalisation, les cavités 20 peuvent être remplies par sérigraphie d'une crème à braser 24 sans utiliser d'écran 7. En effet, la raclette peut être déplacée directement sur la face libre du circuit imprimé 10: la couche C₁ et la première couche isolante 10 (respectivement, la couche C₂ et la deuxième couche isolante 11) servent en effet d'écran 7. Lorsque la raclette atteint une cavité 20, elle force alors la crème à braser 24 dans la cavité 20 de manière similaire à ce qui est fait habituellement avec un écran 7.

Afin d'éviter la présence de crème à braser 24 sur le dessus des couches C₁ et C₂, il est préférable d'utiliser une raclette 6 en polymère. Les quelques billes d'alliage restantes pourront ensuite être éliminées par lavage après l'étape de traitement thermique. Après remplissage des cavités 20, la couche C₁ et la première couche isolante 10 (respectivement, la couche C₂ et la deuxième couche isolante 11) ne sont en revanche pas démoulées. Elles serviront par ailleurs de support au CMS 3 et joueront un rôle de maintien de la crème à braser 24 lors du traitement thermique.

Cette forme de réalisation sans écran 7 permet ainsi de réduire les coûts de fabrication de la carte électronique 1 dans la mesure où il n'est plus nécessaire de réaliser un écran 7 de sérigraphie et d'utiliser des équipements nécessitant une grande précision (plus d'écran 7 à positionner face à face avec le circuit imprimé 2). L'étape S5 de remplissage des cavités 20 est en outre facilitée puisqu'il n'est plus nécessaire de positionner avec précision un écran 7 sur les couches C₁ et C₂.

Selon une autre variante encore, les cavités 20 peuvent être remplies S5 par impression jet d'encre (« jetting » en anglais) de l'alliage métallique accompagné du flux de brasage, par passage dans une vague turbulente d'alliage métallique en fusion accompagné du flux de brasage, par trempage ou passage au travers d'un bain d'alliage métallique en refusion ou encore par brasage à la vague ou par brasage manuel.

Les dimensions des cavités 20 sont choisies de sorte que chaque cavité 20 dévoile au moins une partie la plage de brasage 4 en regard et que la durée de vie de la terminaison 8 du CMS 3 brasée dans cette cavité 20 soit suffisante. Par exemple, chaque cavité 20 peut être dimensionnée de manière à recouvrir et à déborder de la plage de brasage 4. La définition des dimensions de chaque cavité 20 dépend des terminaisons 8 du composant CMS 3 à assembler. Par exemple pour un boîtier de taille 0603, qui comprend plusieurs terminaisons 8, les cavités 20 peuvent présenter des dimensions de l'ordre de 0.5 mm * 1 mm ; pour des boîtiers de taille 1206 : 1 mm * 2 mm ; pour des boîtiers de taille 2010, les cavités 20 peuvent présenter des dimensions de l'ordre de 1.5 mm * 4.5 mm. Pour des boîtiers de type pas fins, la largeur des cavités 20 pourra être par exemple de l'ordre de 0.3 mm. La surface du fond 21 de chaque cavité 20 est donc plus grande que la surface qu'elle dévoile de la plage de brasage 4. Ceci n'est cependant pas limitatif, les cavités 20 pouvant être dimensionnée de manière à ne pas déborder de la plage de brasage 4 qu'elles dévoilent.

Plus la première couche isolante 10 et la couche C₁ sont épaisses, plus la profondeur p des cavités 20 est grande et plus l'épaisseur de crème à braser 24 introduite dans les cavités 20 pourra être importante. En effet, dans le cas où les cavités 20 sont remplies de crème à braser 24 par sérigraphie avec un écran 7, la taille des fenêtres 9 de l'écran 7 de sérigraphie n'est plus limitée par la possibilité de démouler l'écran 7 après remplissage de la cavité 20, puisque la couche C₁ et la première couche isolante 10 restent sur la plage de brasage 4 et ne sont pas démoulées. Par conséquent, la hauteur de crème à braser 24 introduite dans chaque cavité 20 est égale à la somme de la profondeur p de la cavité 20 et de l'épaisseur de l'écran 7, l'épaisseur de l'écran 7 pouvant être faible lorsque l'épaisseur de la couche C₁ et de la première couche isolante 10 est grande.

Plus précisément, la taille d'une fenêtre 9 d'un écran 7 de sérigraphie est limitée par le rapport entre la surface de la fenêtre 9 (dans le plan de l'écran 7, qui est parallèle au plan (X, Y)) et la surface des parois internes de la fenêtre 9 (qui s'étendent perpendiculairement au plan de l'écran 7), qui doit être supérieur ou égal à 0.66. Jusqu'à présent, il était soit nécessaire de réduire l'épaisseur de l'écran 7, ce qui impliquait une diminution de la quantité de crème à braser 24 et donc du standoff des CMS 3, soit d'augmenter la surface de la fenêtre 9, ce qui empêchait d'implanter des CMS 3 à pas fin ou limitait la densité de CMS 3 implantables sur le circuit imprimé 2.

La formation des cavités 20 dans la couche C₁ et dans la première couche isolante 10 éloigne donc la face supérieure de la plage de brasage 4 du point bas des terminaisons 8 conductrices du CMS 3 une fois brasé ce qui permet, de manière tout à fait avantageuse, de lever cette limitation dans la mesure où il devient possible d'augmenter drastiquement la hauteur de crème à braser 24 appliquée sur le circuit imprimé 2, sans modifier pour autant l'épaisseur de l'écran 7 de sérigraphie. Le cas échéant, il est même possible, lors de la réalisation du circuit imprimé 2, d'augmenter autant que nécessaire l'épaisseur de la première couche isolante 10 et de réaliser une fenêtre 9 présentant une surface adaptée à la surface de la cavité 20 associée, son épaisseur étant dictée par le rapport ci-dessus de sorte qu'il reste supérieur à 0.66.

Ainsi, l'invention permet de s'affranchir des difficultés de démoulage de l'écran 7 de sérigraphie, lorsqu'un tel écran 7 est utilisé et rend possible l'implantation de CMS 3 à pas fin et/ou une grande densité de CMS 3 sur la carte électronique 1. Typiquement, il peut être envisagé d'utiliser un écran 7 présentant une épaisseur de l'ordre de 50 µm à 100 µm avec des épaisseurs locales possible de 100 µm à 300 µm en cas de besoin.

On comprendra bien entendu que la suppression de l'écran 7 de sérigraphie, permise par la formation de la cavité 20 dans la couche C₁ et dans la première couche isolante 10, permet également d'implanter des CMS 3 à pas fins sur le circuit imprimé 2 et/ou d'augmenter la densité de CMS 3 sur le circuit imprimé 2, puisque le procédé S de remplissage des cavités 20 ne nécessite pas de démouler un écran 7.

De manière optionnelle, afin d'augmenter la profondeur p de la cavité 20, le procédé S peut en outre comprendre une étape d'application d'une couche additionnelle 19 comprenant un matériau isolant électriquement sur l'une et/ou l'autre des couches C₁, C₂, avant l'étape S7 de traitement thermique et le cas échéant après l'étape de gravure de la couche C₁. Dans l'exemple de réalisation illustré en figure 5, la couche additionnelle 19 est par exemple appliquée sur la couche C₁.

La couche additionnelle 19 peut recouvrir tout ou partie de la couche sous-jacente (C₁ et/ou C₂). Les cavités 20 sont alors formées en partie dans ladite couche additionnelle 19. En d'autres termes, la partie supérieure 25 des cavités 20 peut être réalisée dans la couche additionnelle 19. Le cas échéant, cette partie supérieure 25 peut présenter des dimensions plus grandes que le reste de la cavité 20 associée.

La couche additionnelle 19 peut notamment comprendre tout matériau isolant électriquement. Le cas échéant, le matériau constitutif de la couche additionnelle 19 peut être thermo-conducteur. Par ailleurs, selon l'environnement thermique et vibratoire et afin d'augmenter encore la durée de vie du circuit imprimé 2, le matériau de la couche additionnelle 19 peut être choisi de manière à présenter un coefficient de dilatation thermique en Z plus grand que celui de l'alliage métallique.

Typiquement, la couche additionnelle 19 peut comprendre l'un au moins des matériaux suivants : fibres de verre, résine époxy, polyimide, polyester, polymère, téflon.

La couche additionnelle 19 peut être appliquée par tout moyen sur la couche C₁, avant ou après la formation des cavités 20 dans la couche C₁ et dans la première couche isolante 10.

Dans une forme de réalisation, la couche additionnelle 19 peut être rapportée et fixée sur la couche C₁ et/ou C₂, par exemple par lamination ou collage à l'aide d'une couche adhésive. La couche adhésive peut comprendre tout type de matériau adhésif conventionnellement utilisé dans le domaine des circuits imprimés afin d'adhérer des couches ensemble, typiquement une colle époxy. La partie supérieure 25 des cavités 20 peut alors être préformée dans la couche additionnelle 19 avant que celle-ci ne soit posée sur la couche C₁ et/ou C₂, ou encore après sa fixation.

Par exemple, la partie supérieure 25 des cavités 20 peuvent être formées par découpe de la couche additionnelle 19. La découpe de la partie supérieure 25 des cavités 20 dans la couche additionnelle 19 étant analogue à celle du reste des cavités 20 (ex : découpe de type fraisage mécanique ou perçage mécanique ou perçage laser) dans les couches isolantes 10, 11, elle ne sera pas détaillée à nouveau ici.

Le cas échéant, la couche additionnelle 19 peut comprendre un circuit imprimé 2, qui peut être rapporté et fixé sur la couche C₁ et/ou C₂ par brasage ou collage. Dans une forme de réalisation, la partie supérieure 25 des cavités 20 sont alors réalisées dans le circuit imprimé 2. Le circuit imprimé 2 formant la couche additionnelle 19 peut alors s'étendre sur tout ou partie la couche C₁. En variante, il peut s'étendre uniquement localement, sous le CMS 3. Cette forme de réalisation est particulièrement intéressante dans le cas où le CMS 3 comprend des pattes 8 en ailes de mouette, dont l'assemblage a tendance à casser.

On notera que le moment où la couche additionnelle 19 est placée sur la couche C₁ et/ou C₂ dépend de la technique de dépôt de la couche additionnelle 19 et de formation des cavités 20. Par exemple, dans le cas où les cavités 20 sont réalisées par perçage laser, il est préférable de former les cavités 20 dans la couche additionnelle 19 avant son dépôt sur la couche C₁ et/ou C₂, pour garantir l'arrêt du laser.

L'ajout de la couche additionnelle 19 permet d'augmenter la profondeur p des cavités 20 et d'augmenter ainsi le standoff des CMS 3. Cette couche additionnelle 19 est en outre intéressante lorsque l'épaisseur de la première couche isolante 10 est faible et ne permet donc pas de former à elle seule des cavités 20 ayant une profondeur p suffisante pour atteindre la durée de vie désirée.

Le cas échéant, la couche additionnelle 19 peut n'être appliquée que sur une partie de la couche C₁, par exemple sous certains CMS 3 seulement, comme illustré en figure 5. Un écran de sérigraphie étagé peut alors être utilisé afin de remplir les cavités 20 sous-jacentes à la couche additionnelle 19 en même temps que les autres cavités 20.

L'étape S5 de traitement thermique peut notamment comprendre une refusion (« reflow soldering » en anglais) de l'alliage métallique présent dans la crème à braser 24. Pour cela, au cours d'une première sous-étape dite de montée en température (« ramp up » en anglais), la température est progressivement augmentée. Cette étape de montée en température peut, de manière connue en soi, être réalisée suivant une pente comprise entre 1°C/s et 4°C/s jusqu'à 100°C à 150°C (au maximum 7°C/s, pente de température maximum préconisée par les composants CMS 3 avant brasage).

Au cours d'une deuxième sous-étape dite de préchauffage (« preheat » en anglais) s'opère l'opération de séchage des flux (« soak » or « preflow » en anglais) et de préparation de nettoyage des terminaisons 8 de brasage du circuit imprimé 2 et du CMS 3, la température est augmentée progressivement jusqu'à environ 170°C et maintenue pendant au moins une minute et demie à plusieurs minutes (suivant les flux utilisés) afin de permettre l'évaporation des parties volatiles du flux de brasage et l'homogénéité de température de tous les composants avant la phase de refusion.

Au cours d'une troisième sous-étape dite de refusion (« reflow » en anglais), la température est à nouveau augmentée jusqu'à atteindre une température critique, généralement supérieure de 20 à 50 °C au-dessus de la température de fusion de l'alliage de l'alliage métallique utilisé. Lorsque la température passe par le point de fusion de l'alliage métallique contenu dans la crème à braser 24 (soit par exemple environ 180°C lorsque l'alliage métallique comprend un alliage étain/plomb 63/37, de l'ordre de 217°C dans le cas d'un alliage métallique étain/argent/cuivre 95.6/3.0/0.5 et de l'ordre de 221°C dans le cas d'un alliage métallique étain/argent 96.5/3.5), l'alliage métallique fond 21. On notera qu'à tout moment, l'alliage métallique qui est liquide reste en contact avec les terminaisons 8 du CMS 3 et la plage de brasage 4 de la couche C₃ sous l'effet de la mouillabilité.

De préférence, l'augmentation de la température lors de l'étape de refusion est rapide et en tout état de cause plus rapide que l'étape de montée en température afin d'éviter que le CMS 3 ne subisse longtemps des températures élevées. Le circuit imprimé 2 peut par ailleurs être maintenu à la température critique supérieure à la température de fusion de l'alliage pendant une durée qui peut être comprise entre vingt et quatre-vingt-dix seconde, suivant la masse thermique des composants à assembler. Ce temps au-dessus de la température de fusion de l'alliage permet la création des intermétalliques qui assureront le maintien des composants entre l'alliage métallique et les parties à assembler.

Au cours d'une quatrième sous-étape, le circuit imprimé 2 est refroidi rapidement jusqu'à la température ambiante. Lorsque la température repasse par le point de fusion et devient inférieure à la température de fusion de l'alliage métallique, celui-ci se solidifie, formant ainsi le joint de brasure 5. La première couche isolante 10 (qui s'étend entre la première couche C₁ et la couche C₃) garantit alors un standoff minimum entre la face supérieure de la plage de brasage 4 et le point bas des terminaisons 8 conductrices du CMS 3 une fois brasé, qui ne peut être inférieur à l'épaisseur de la première couche isolante 10. Le cas échéant, lorsqu'une couche additionnelle 19 isolante est appliquée sur la couche C₁, le standoff minimum est au moins égal à la somme de l'épaisseur de la première couche isolante 10 et de l'épaisseur de la couche additionnelle 19.

On notera que le flux de brasage s'évapore progressivement lors de l'étape de montée en température (et de préchauffage/séchage), laissant ainsi uniquement l'alliage métallique sur la plage de brasage 4. Le joint de brasure 5 ne comprend donc que l'alliage métallique.

Le traitement thermique de refusion est bien connu dans le domaine technique du brasage des CMS 3, de sorte qu'il n'est pas nécessaire de le détailler davantage ici. Par ailleurs, les températures, pentes et durées des différentes étapes du traitement thermique sont données ici à titre d'exemple et dépendent bien entendu de la crème à braser 24 utilisée. Un homme du métier saura donc les adapter sans difficulté selon le type d'alliage métallique et de flux de brasage utilisés.

Comme on peut le voir, le procédé S de l'invention permet d'utiliser tout type de crème à braser 24, et en particulier des crèmes à braser sans plomb, permettant ainsi de respecter les normes actuelles et en particulier la directive européenne RoHS n°2002/95/CE - bannissement du Plomb, Chrome hexavalent, Mercure, Cadmium, Polybromobiphényle et décabromodiphényl-éthers. Par exemple, l'alliage métallique de la crème à braser 24 peut comprendre l'une des compositions suivantes, qui sont les plus couramment utilisés : étain/plomb 63/37 ou 10/90 ou 90/10, étain/plomb/Argent 62/36/2, pour les produits exemptés de la directive Rohs ou des alliages étain/argent 96.5/3.5., étain/Argent/Cuivre 96.5/3.8/0.7 ou 96.6/3.0/0.5 ou 98.5/1.0/0.5. Cette technique s'adapte à tous type d'alliage (comprenant du bismuth, de l'antimoine, etc.)

De manière connue en soi, le flux de brasage dépend du type d'alliage métallique en suspension dans la crème à braser 24 et du process d'assemblage avec ou sans nettoyage. Le flux de brasage comprend généralement une résine (typiquement une résine naturelle, modifiée ou synthétique), des agents d'activation et des additifs permettant d'optimiser la sérigraphie et la refusion. Le rôle du flux de brasage est d'assurer le décapage des plages de brasage 4 (à l'aide des activateurs), d'assurer leur protection pendant les étapes de montée en température et de jouer un rôle tensioactif pour favoriser le mouillage de l'alliage métallique. Par exemple, le flux de brasage peut comprendre de la colophane.

Il peut être avantageux de braser des terminaisons 8 d'un même CMS 3 dans des cavités 20 de différente profondeur p, ou de braser au moins une terminaison 8 en surface tandis que les autres terminaisons 8 sont brasées dans des cavités 20. En effet, d'une manière générale, les efforts appliquées aux terminaisons 8 ne sont pas identiques pour un même CMS 3 : l'étagement du brasage des terminaisons 8 permet ainsi d'adapter le brasage aux efforts reçus par chaque terminaison 8.

Par exemple, il est possible de braser une partie des terminaisons 8 en surface, sur la couche C₁ (respectivement, la couche C₂) et le reste des terminaisons 8 dans des cavités 20. De préférence, les terminaisons 8 subissant le plus de contraintes sont brasées dans des cavités 20, afin d'augmenter leur durée de vie en réduisant l'angle de cisaillement pour un même déplacement relatif du CMS 3 par rapport au circuit imprimé 2, tandis que les autres peuvent être brasées en surface.

Cette forme de réalisation est notamment avantageuse dans le cas de CMS 3 du type BGA (acronyme de Ball Grid Array pour matrice de billes) : les terminaisons 8 situées dans les zones adjacentes aux coins du BGA sont exposées à davantage de contraintes que les terminaisons 8 situées en partie centrale du BGA ou au milieu des côtés du BGA. Les terminaisons 8 situées dans ces zones peuvent donc être brasées dans des cavités 20.

Cette forme de réalisation peut également être avantageuse lorsque le CMS 3 comprend des pattes : les pattes situées en partie centrale du CMS 3 peuvent être brasées en surface (respectivement, dans une cavité 20 à une première profondeur p) tandis que les pattes situées à l'extrémité du CMS 3 peuvent être brasées dans une cavité 20 (respectivement, dans une cavité 20 à une deuxième profondeur p, supérieure à la première profondeur p).

Des exemples de carte électronique 1 comprenant différents CMS 3 fixés conformément au procédé S de l'invention vont à présent être décrit en référence aux figures 6 à 8.

La figure 6 illustre une carte électronique 1 comprenant deux couches conductrices de peau C₁ et C₂ et six couches conductrices internes C₃, C₄, C₅, C₆, C₇ et C₈ qui s'étendent entre les couches C₁ et C₂ et sont séparées deux à deux par des couches isolantes 10, 11, 12, 30, 31, 32 et 33.

Un premier CMS 3 (CMS#1) est brasé dans des cavités 20 formées dans la couche C₁ et dans la première couche isolante 10. Comme on peut le voir sur cette figure, les parois verticales 22 de ces cavités 20 sont partiellement métallisées (sur une moitié de la périphérie de la paroi verticale 22 des cavités 20, au fond 21 et sur une partie de la sortie des cavités 20 pour former des demi-collerettes 23).

Un deuxième CMS 3 (CMS#2) est brasé de manière conventionnelle sur la couche C₁.

Un troisième et un quatrième composants (CMS#3 et CMS#4) de technologie traversante montés de manière non conventionnelle « en surface » sont brasés dans des cavités 20 formées dans la couche C₁ et dans la première (10), la troisième (12), une quatrième (30) et une cinquième (31) couche isolante. Comme on peut le voir sur cette figure, les parois verticales 22 de ces cavités 20 et leurs sorties sont métallisées au travers d'une collerette 23.

Un cinquième CMS 3 (CMS#5), comprenant des pattes en aile de mouette, est brasé dans des cavités 20 formées de la couche C₁ à la couche C₄ à travers la première couche isolante 10, la couche C₃ et la troisième couche isolante 12. Comme on peut le voir sur cette figure, les parois verticales 22 de ces cavités 20 et leurs sorties sont métallisées au travers d'une collerette 23.

Un sixième CMS 3 (CMS#6), comprenant des pattes 8 en aile de mouette, est brasé dans des cavités 20 formées dans la couche C₂ et dans la deuxième couche isolante 11. Comme on peut le voir sur cette figure, seul le fond 21 de ces cavités 20 est métallisé.

Un septième CMS 3 (CMS#7), comprenant des pattes 8 en aile de mouette, est brasé de manière conventionnelle sur la couche C₂.

Un huitième CMS 3 (CMS#8) est brasé dans des cavités 20 formées dans la couche C₂ et dans la deuxième couche isolante 11. Comme on peut le voir sur cette figure, les parois verticales 22 de ces cavités 20 sont partiellement métallisées (sur une moitié de la périphérie de la paroi verticale 22 des cavités 20, sur une moitié de leur fond 21 et sur une partie de la sortie des cavités 20 pour former des demi-collerettes 23).

Un neuvième CMS 3 (CMS#9), qui peut correspondre à un BGA et comprend une pluralité de terminaisons 8, est brasé en partie de manière conventionnelle sur la couche C₂ et en partie dans des cavités 20 formées dans la couche C₂ et dans la deuxième couche isolante 11. Les terminaisons 8 brasées dans des cavités 20 correspondent ici aux terminaisons 8 situées aux extrémités du neuvième CMS 3.

Ainsi, cette carte électronique 1 comprend neuf CMS 3 de tailles différentes et présentent toutes un standoff adapté au CMS 3. On voit plus particulièrement que le standoff du deuxième et du septième CMS (CMS#2 et CMS#7) est faible, tandis que le standoff des autres CMS 3 est élevé et au moins égal au nombre de couches isolantes 10, 11, 12 et de couches conductrices entre la couche C₁ ou C₂ sur laquelle le CMS 3 est fixé et la plage de brasage 4 du CMS 3.

La figure 7 illustre une carte électronique 1 comprenant deux couches conductrices de peau C₁ et C₂ et quatre couches conductrices internes C₃, C₄, C₅ et C₆, qui s'étendent entre les couches C₁ et C₂ et sont séparées deux à deux par des couches isolantes 10, 11, 12, 30, 31.

Un premier CMS 3 (CMS#1) est brasé de manière conventionnelle sur la couche C₁.

Un deuxième CMS 3 (CMS#2) est brasé dans des cavités 20 formées dans la première couche isolante 10. Comme on peut le voir sur cette figure, les parois verticales 22 et la sortie de ces cavités 20 ne sont pas métallisées.

Un troisième CMS 3 (CMS#3) est brasé dans des cavités 20 formées dans la première couche isolante 10 et dans la troisième couche isolante 12. Comme on peut le voir sur cette figure, les parois verticales 22 et la sortie de ces cavités 20 ne sont pas non plus métallisées.

Un quatrième CMS 3 (CMS#4) est brasé dans une cavité 20 formée dans la deuxième couche isolante 11 et dans une cinquième couche isolante 31. Comme on peut le voir sur cette figure, les parois verticales 22 et le fond 21 de ces cavités 20 sont métallisées, mais pas leur sortie.

Ainsi, cette carte électronique 1 comprend quatre CMS 3 de taille différente et présentent toutes un standoff adapté au CMS 3. On voit plus particulièrement que le standoff du premier CMS 3 est faible, tandis que le standoff des deuxième, troisième et quatrième CMS 3 est élevé. Par exemple, le standoff du troisième CMS 3 (CMS#3) est égal à l'épaisseur de la couche C₁, de la première couche isolante 10, de la couche C₃, et de la troisième couche isolante 12.

Ainsi, cette carte électronique 1 comprend quatre CMS 3 de taille différente et présentent toutes un standoff adapté au CMS 3. On voit plus particulièrement que le standoff du premier CMS (CMS#1) est faible, tandis que le standoff du troisième et du quatrième (CMS#3 et CMS#4) est élevé et égal, respectivement, à l'épaisseur de la première et de la troisième couche isolante 10, 12 et à l'épaisseur de la deuxième et de la cinquième couche isolante 11, 31.

La figure 8 illustre une carte électronique 1 comprenant deux couches conductrices de peau C₁ et C₂ et quatre couches conductrices internes C₃, C₄, C₅ et C₆, qui s'étendent entre les couches C₁ et C₂ et sont séparées deux à deux par des couches isolantes 10, 11, 12, 30, 31.

Un premier CMS 3 (CMS#1), qui peut être du type LCC (acronyme anglais de Leadless Chip Carrier pour boîtier sans broche), LGA (acronyme anglais de Land Grid Array pour matrice de plages) ou QFN (acronyme anglais de Quad Flat No-lead), est brasé dans des cavités 20 formées depuis la couche C₁ dans la première couche isolante 10. Comme on peut le voir sur cette figure, les parois de ces cavités 20 ne sont pas métallisées.

Un deuxième CMS 3 (CMS#2), qui comprend des terminaisons 8 du type pattes en J, est brasé dans des cavités 20 formées depuis la couche C₁ dans la première et dans la troisième couche isolante 10, 12. Comme on peut le voir sur cette figure, les parois verticales 22 et la sortie de ces cavités 20 ne sont pas non plus métallisées.

Un troisième CMS 3 (CMS#3), qui peut être du type composant de technologie traversante assemblé en « pin in paste » (patte à travers la crème à braser), est brasé dans une cavité 20 formée depuis la couche C₂ dans la deuxième (11), la cinquième (31), la quatrième (30) et la troisième (12) couche isolante. Comme on peut le voir sur cette figure, les parois verticales 22 et le fond 21 de cette cavité 20 sont métallisées, mais pas sa sortie (pas de collerette 23).

Un quatrième CMS 3 (CMS#4), qui peut par exemple être un BGA, est brasé dans une cavité 20 formée depuis la couche C₂ dans la deuxième et la cinquième couche isolante 11, 31. Comme on peut le voir sur cette figure, les parois verticales 22 et le fond 21 de ces cavités 20 sont métallisées, mais pas leur sortie (pas de collerette 23).

## Revendications

1. Procédé de fabrication (S) d'une carte électronique (1), ladite carte électronique (1) comprenant un circuit imprimé (2) multicouche, ledit circuit imprimé (2) comprenant au moins quatre couches conductrices (C₁, C₂, C₃, C₄, C₅, C₆, C₇, C₈) séparées deux à deux par des couches isolantes (10, 11, 12, 30, 31, 32, 33), dont :
- une première et une deuxième couche conductrice de peau (C₁, C₂) fixées sur une première et une deuxième couche isolante (10, 11), respectivement, la première couche conductrice de peau (C₁) étant sensiblement plane et définissant un plan (X ; Y) normal à un axe Z,
- une première et une deuxième couche conductrice interne (C₃, C₄), s'étendant entre la première et la deuxième couche isolante (10, 11), respectivement, et séparées par une troisième couche isolante (12), au moins la première couche conductrice interne (C₃) étant traitée de manière à former au moins une plage de brasage (4),
le procédé de fabrication (S) étant **caractérisé en ce qu'**il comprend les étapes suivantes :
- former (S1, S4) une première cavité (20) dans la première couche conductrice de peau (C₁) et dans la première couche isolante (10), en face de la plage de brasage (4) de la première couche conductrice interne (C₃), de sorte qu'au moins une partie de la plage de brasage (4) soit dévoilée,
- remplir (S5) la première cavité (20) avec un alliage métallique accompagné d'un flux de brasage (24),
- placer (S6) un premier composant (3) électronique en contact avec la première couche conductrice de peau (C₁) en face de la première cavité (20),
- appliquer un traitement thermique (S7) au circuit imprimé (2) sur lequel est placé le premier composant (3) afin de transformer l'alliage métallique accompagné du flux de brasage (24) en joint de brasure (5) de manière à fixer le premier composant (3) au circuit imprimé (2).

2. Procédé de fabrication (S) selon la revendication 1, dans lequel le premier composant (3) comprend au moins une terminaison et dans lequel le procédé comprend la formation (S1, S4) d'autant de premières cavités (20) dans la première couche conductrice de peau que le composant électronique comprend de terminaisons.

3. Procédé de fabrication (S) selon l'une des revendications 1 et 2, dans lequel la première cavité (20) est formée (S1, S4) à l'aide de l'une au moins des techniques suivantes : photolithographie en surface, perçage laser, perçage mécanique, découpe mécanique.

4. Procédé de fabrication (S) selon l'une des revendications 1 à 3, comprenant en outre une étape de métallisation (S2) de la première cavité (20) afin de déposer une couche métallique (13) dans la première cavité (20).

5. Procédé de fabrication (S) selon la revendication 4, comprenant en outre une étape supplémentaire (S3) dans laquelle une partie de la couche métallique (13) de la première cavité (20) est retirée préalablement à l'étape de remplissage (S5) de la première cavité (20).

6. Procédé de fabrication (S) selon la revendication 5, dans lequel le retrait (S3) partiel de la couche métallique (13) est réalisé par laser ou par découpe mécanique ou par perçage mécanique.

7. Procédé de fabrication (S) selon l'une des revendications 1 à 6, dans lequel la première couche conductrice interne (C₃) comprend une plage de brasage (4) supplémentaire et le procédé de fabrication (S) comprend en outre les étapes supplémentaires suivantes, préalablement à l'étape de traitement thermique :
- former (S1, S4) une deuxième cavité (20) dans la première couche isolante (10), en face de la plage de brasage (4) supplémentaire, de sorte qu'au moins une partie supplémentaire de la plage de brasage (4) supplémentaire soit dévoilée,
- remplir (S5) la deuxième cavité (20) avec l'alliage métallique accompagné d'un flux de brasage (24), et
- placer (S6) un deuxième composant (3) électronique en face de la deuxième cavité (20),
les étapes de remplissage (S5) des première et deuxième cavités (20) et de placement des composants (3) étant réalisées sensiblement simultanément.

8. Procédé de fabrication (S) selon l'une des revendications 1 à 7, comprenant en outre une étape de gravure de la première couche conductrice de peau (C₁).

9. Procédé de fabrication (S) selon l'une des revendications 1 à 8, dans lequel la première cavité (20) est remplie conformément à l'une au moins des techniques de remplissage (S5) suivantes : sérigraphie avec écran (7) de sérigraphie, sérigraphie sans écran (7) de sérigraphie, impression jet d'encre, passage dans une vague turbulente, par trempage ou passage au travers d'un bain d'alliage métallique en refusion, brasage à la vague, brasage manuel.

10. Procédé de fabrication (S) selon l'une des revendications 1 à 9, dans lequel la deuxième couche conductrice interne (C₄) est traitée de manière à former au moins une plage de brasage (4), le procédé de fabrication (S) comprenant en outre les étapes suivantes, préalablement à l'étape (S7) de traitement thermique :
- former (S1, S4) une troisième cavité (20) dans la première couche isolante (10) et dans la troisième couche isolante (12), en face de la plage de brasage (4) de la deuxième couche conductrice interne (C₄), de sorte qu'au moins une partie de la plage de brasage (4) de la deuxième couche conductrice interne (C₄) soit dévoilée,
- remplir (S5) la troisième cavité (20) avec l'alliage métallique accompagné d'un flux de brasage (24), et
- placer (S6) un troisième composant (3) électronique additionnel en face de la troisième cavité (20).

11. Procédé de fabrication (S) selon l'une des revendications 1 à 10, dans lequel la deuxième couche conductrice interne (C₄) est traitée de manière à former au moins une plage de brasage (4), le procédé de fabrication (S) comprenant en outre les étapes suivantes, préalablement à l'étape de traitement thermique :
- former (S1, S4) une quatrième cavité (20) dans la deuxième couche conductrice de peau (C₂) et dans la deuxième couche isolante (11), en face de la plage de brasage (4) de la deuxième couche conductrice interne (C₄), de sorte qu'au moins une partie de la plage de brasage (4) de la deuxième couche conductrice interne (C₄) soit dévoilée,
- remplir (S5) la quatrième cavité (20) avec l'alliage métallique accompagné d'un flux de brasage (24), et
- placer (S6) un quatrième composant (3) électronique en face de la quatrième cavité (20).

12. Procédé selon l'une des revendications 1 à 11, comprenant en outre, préalablement à l'étape (S7) de traitement thermique, une étape au cours de laquelle une couche additionnelle (19) comprenant un matériau isolant électriquement est appliquée sur la première couche conductrice de peau (C₁), la première cavité (20) étant formée en partie dans ladite couche additionnelle (19) et le premier composant (3) étant placé sur la couche additionnelle (19).

13. Procédé selon la revendication 12, dans lequel le matériau électriquement isolant de la couche additionnelle (19) présente un premier coefficient de dilatation thermique suivant l'axe Z, l'alliage métallique présente un deuxième coefficient de dilatation thermique suivant l'axe Z, et dans lequel le premier coefficient de dilatation thermique est plus grand que le deuxième coefficient de dilatation thermique.

14. Carte électronique (1) comprenant un circuit imprimé (2) multicouche, ledit circuit imprimé (2) comprenant au moins quatre couches conductrices (C₁, C₂, C₃, C₄, C₅, C₆, C₇, C₈) séparées deux à deux par des couches isolantes (10, 11, 12), dont :
- une première et une deuxième couche conductrices de peau (C₁, C₂) fixées sur une première et une deuxième couche isolante (10, 11), respectivement, la première couche conductrice étant sensiblement plane et définissant un plan (X ; Y) normal à un axe Z,
- une première et une deuxième couches conductrices internes (C₃, C₄), s'étendant entre la première et la deuxième couche isolante (10, 11), respectivement, et séparées par une troisième couche isolante (12), au moins la première couche conductrice interne (C₃) étant traitée de manière à former au moins une plage de brasage (4),
- une première cavité (20), formée dans la première couche conductrice de peau (C₁) et dans la première couche isolante (10), ladite première cavité (20) dévoilant au moins en partie la plage de brasage (4), et
un premier composant (3) électronique monté en surface comprenant au moins une terminaison (8), ledit premier composant (3) étant placé sur la couche conductrice de peau (C₁) de sorte à être en contact ou à distance de la première couche conductrice de peau (C₁) par l'intermédiaire d'un joint de brasure (5), la terminaison (8) du premier composant (3) étant fixée dans la première cavité (20) par l'intermédiaire du joint de brasure (5).

15. Carte électronique (1) selon la revendication 14, dans laquelle une surface de la première cavité, dans le plan (X ; Y), étant au moins égale à 0.04 mm².

16. Carte électronique (1) selon l'une des revendications 14 et 15, comprenant autant de premières cavités (20) que le composant électronique n'a de terminaisons.

17. Carte électronique (1) selon l'une des revendications 14 à 16, dans laquelle la première cavité (20) comprend une couche métallique (13) de métallisation.

18. Carte électronique (1) selon la revendication 17, dans laquelle la première cavité (20) est recouverte partiellement d'une couche métallique (13) de métallisation.

19. Carte électronique (1) selon l'une des revendications 14 à 18, comprenant en outre un vernis épargne (17) appliqué sur la première couche conductrice (C₁) et sur le dessus de la couche isolante (10) au moins partiellement dévoilée et/ou une finition métallique (18) appliquée sur la première couche conductrice de peau (C₁) et les zones de la première couche conductrice interne (C₃) qui forment la première cavité (20).

20. Carte électronique (1) selon l'une des revendications 14 à 19, dans laquelle le premier composant (3) comprend une terminaison (8) supplémentaire, ladite terminaison (8) étant fixée sur la première couche conductrice de peau (C₁) par l'intermédiaire d'un joint de brasure (5).

21. Carte électronique (1) selon l'une des revendications 14 à 20, dans lequel la deuxième couche conductrice interne (C₄) est traitée de manière à former au moins une plage de brasage (4), la carte électronique (1) comprenant en outre :
- une deuxième cavité (20), formée dans la première couche isolante (10) et dans la troisième couche isolante (12), en face de la deuxième couche conductrice interne (C₄), et
- un deuxième composant (3) électronique monté en surface comprenant au moins une terminaison (8), ledit deuxième composant (3) étant en contact ou à distance de la première couche conductrice de peau (C₁), la terminaison (8) du deuxième composant (3) étant fixée dans la deuxième cavité (20) par l'intermédiaire d'un joint de brasure (5).

22. Carte électronique (1) selon l'une des revendication 14 à 21, dans laquelle le premier composant (3) comprend en outre une terminaison (8) supplémentaire, la deuxième couche conductrice interne (C₄) est traitée de manière à former au moins une plage de brasage (4) et la carte électronique (1) comprend en outre une cavité (20) supplémentaire, formée dans la première couche isolante (10) et dans la troisième couche isolante (12), en face de la plage de brasage (4) de la deuxième couche conductrice interne (C₄), la terminaison (8) supplémentaire du composant (3) étant fixée sur ladite plage de brasage (4) dans la cavité (20) supplémentaire par l'intermédiaire d'un joint de brasure (5).

23. Carte électronique (1) selon l'une des revendications 14 à 22, dans laquelle la deuxième couche conductrice interne (C₄) est traitée de manière à former au moins une plage de brasage (4), la carte électronique (1) comprenant en outre :
- une quatrième cavité (20), formée dans la deuxième couche conductrice de peau (C₂) et dans la deuxième couche isolante (11), en face de la deuxième couche conductrice interne (C₄), et
- un quatrième composant (3) électronique monté en surface comprenant au moins une terminaison (8), ledit quatrième composant (3) étant en contact ou à distance de la deuxième couche conductrice de peau (C₂), la terminaison (8) du quatrième composant (3) étant fixée dans la quatrième cavité (20) par l'intermédiaire d'un joint de brasure (5).

## Patentansprüche

1. Verfahren zur Herstellung (S) einer elektronischen Leiterplatte (1), wobei die elektronische Leiterplatte (1) eine mehrschichtige gedruckte Schaltung (2) umfasst, wobei die gedruckte Schaltung (2) mindestens vier leitende Schichten (C₁, C₂, C₃, C₄, C₅, C₆, C₇, C₈) umfasst, die jeweils paarweise durch Isolierschichten (10, 11, 12, 30, 31, 32, 33) getrennt sind, wobei:
- eine erste und eine zweite leitende Mantelschicht (C₁, C₂) jeweils auf einer ersten und einer zweiten Isolierschicht (10, 11) befestigt sind, wobei die erste leitende Mantelschicht (C₁) im Wesentlichen eben ist und eine Ebene (X; Y) definiert, die senkrecht zu einer Achse Z verläuft,
- eine erste und eine zweite leitende Innenschicht (C₃, C₄) sich jeweils zwischen der ersten und der zweiten Isolierschicht (10, 11) erstrecken und durch eine dritte Isolierschicht (12) getrennt sind, wobei mindestens die erste leitende Innenschicht (C₃) so behandelt ist, dass mindestens ein Lötbereich (4) gebildet wird,
wobei das Herstellungsverfahren (S) **dadurch gekennzeichnet ist, dass** es die folgenden Schritte umfasst:
- Bilden (S1, S4) einer ersten Vertiefung (20) in der ersten leitenden Mantelschicht (C₁) und in der ersten Isolierschicht (10) gegenüber dem Lötbereich (4) der ersten leitenden Innenschicht (C₃), so dass mindestens ein Teil des Lötbereichs (4) freigelegt wird,
- Füllen (S5) der ersten Vertiefung (20) mit einer Metalllegierung in Begleitung eines Lötflussmittels (24),
- Platzieren (S6) eines ersten elektronischen Bauteils (3) in Kontakt mit der ersten leitenden Mantelschicht (C₁) gegenüber der ersten Vertiefung (20),
- Anwenden einer Wärmebehandlung (S7) auf die gedruckte Schaltung (2), auf der das erste Bauteil (3) platziert ist, um die Metalllegierung in Begleitung des Lötflussmittels (24) in eine Lötnaht (5) umzuwandeln, um das erste Bauteil (3) auf der gedruckten Schaltung (2) zu befestigen.

2. Herstellungsverfahren (S) nach Anspruch 1, wobei das erste Bauteil (3) mindestens einen Anschluss umfasst und wobei das Verfahren die Bildung (S1, S4) von ebenso vielen ersten Vertiefungen (20) in der ersten leitenden Mantelschicht umfasst, wie das elektronische Bauteil Anschlüsse umfasst.

3. Herstellungsverfahren (S) nach einem der Ansprüche 1 und 2, wobei die erste Vertiefung (20) mit Hilfe mindestens einer der folgenden Techniken gebildet (S1, S4) wird: Oberflächenphotolithografie, Laserbohren, mechanisches Bohren, mechanisches Schneiden.

4. Herstellungsverfahren (S) nach einem der Ansprüche 1 bis 3, das ferner einen Schritt der Metallisierung (S2) der ersten Vertiefung (20) umfasst, um eine Metallschicht (13) in der ersten Vertiefung (20) abzulegen.

5. Herstellungsverfahren (S) nach Anspruch 4, das ferner einen zusätzlichen Schritt (S3) umfasst, bei dem ein Teil der Metallschicht (13) der ersten Vertiefung (20) vor dem Füllschritt (S5) der ersten Vertiefung (20) entfernt wird.

6. Herstellungsverfahren (S) nach Anspruch 5, wobei das teilweise Entfernen (S3) der Metallschicht (13) mittels Laser oder durch mechanisches Schneiden oder mechanisches Bohren erfolgt.

7. Herstellungsverfahren (S) nach einem der Ansprüche 1 bis 6, wobei die erste leitende Innenschicht (C₃) einen zusätzlichen Lötbereich (4) umfasst und das Herstellungsverfahren (S) vor dem Wärmebehandlungsschritt ferner die folgenden zusätzlichen Schritte umfasst:
- Bilden (S1, S4) einer zweiten Vertiefung (20) in der ersten Isolierschicht (10) gegenüber dem zusätzlichen Lötbereich (4), so dass mindestens ein zusätzlicher Teil des zusätzlichen Lötbereichs (4) freigelegt wird,
- Füllen (S5) der zweiten Vertiefung (20) mit der Metalllegierung in Begleitung eines Lötflussmittels (24), und
- Platzieren (S6) eines zweiten elektronischen Bauteils (3) gegenüber der zweiten Vertiefung (20),
wobei die Schritte des Füllens (S5) der ersten und zweiten Vertiefung (20) und des Platzierens der Bauteile (3) im Wesentlichen gleichzeitig durchgeführt werden.

8. Herstellungsverfahren (S) nach einem der Ansprüche 1 bis 7, das ferner einen Schritt des Ätzens der ersten leitenden Mantelschicht (C₁) umfasst.

9. Herstellungsverfahren (S) nach einem der Ansprüche 1 bis 8, wobei die erste Vertiefung (20) gemäß mindestens einer der folgenden Fülltechniken (S5) gefüllt wird: Siebdruck mit Siebdruckrahmen (7), Siebdruck ohne Siebdruckrahmen (7), Tintenstrahldruck, Durchlaufen einer turbulenten Welle, durch Eintauchen oder Durchlaufen eines Bades aus geschmolzener Metalllegierung, Wellenlöten, manuelles Löten.

10. Herstellungsverfahren (S) nach einem der Ansprüche 1 bis 9, wobei die zweite leitende Innenschicht (C₄) so behandelt wird, dass mindestens ein Lötbereich (4) gebildet wird, wobei das Herstellungsverfahren (S) vor dem Wärmebehandlungsschritt (S7) ferner die folgenden Schritte umfasst:
- Bilden (S1, S4) einer dritten Vertiefung (20) in der ersten Isolierschicht (10) und in der dritten Isolierschicht (12) gegenüber dem Lötbereich (4) der zweiten leitenden Innenschicht (C₄), so dass mindestens ein Teil des Lötbereichs (4) der zweiten leitenden Innenschicht (C₄) freigelegt wird,
- Füllen (S5) der dritten Vertiefung (20) mit der Metalllegierung in Begleitung eines Lötflussmittels (24), und
- Platzieren (S6) eines weiteren dritten elektronischen Bauteils (3) gegenüber der dritten Vertiefung (20).

11. Herstellungsverfahren (S) nach einem der Ansprüche 1 bis 10, wobei die zweite leitende Innenschicht (C₄) so behandelt wird, dass mindestens ein Lötbereich (4) gebildet wird, wobei das Herstellungsverfahren (S) vor dem Wärmebehandlungsschritt ferner die folgenden Schritte umfasst:
- Bilden (S1, S4) einer vierten Vertiefung (20) in der zweiten leitenden Mantelschicht (C₂) und in der zweiten Isolierschicht (11) gegenüber dem Lötbereich (4) der zweiten leitenden Innenschicht (C₄), so dass mindestens ein Teil des Lötbereichs (4) der zweiten leitenden Innenschicht (C₄) freigelegt wird,
- Füllen (S5) der vierten Vertiefung (20) mit der Metalllegierung in Begleitung eines Lötflussmittels (24), und
- Platzieren (S6) eines vierten elektronischen Bauteils (3) gegenüber der vierten Vertiefung (20).

12. Verfahren nach einem der Ansprüche 1 bis 11, das ferner vor dem Wärmebehandlungsschritt (S7) einen Schritt umfasst, bei dem eine weitere Schicht (19), die ein elektrisch isolierendes Material umfasst, auf die erste leitende Mantelschicht (C₁) aufgebracht wird, wobei die erste Vertiefung (20) teilweise in der weiteren Schicht gebildet wird (19) gebildet und das erste Bauteil (3) auf der weiteren Schicht (19) platziert wird.

13. Verfahren nach Anspruch 12, wobei das elektrisch isolierende Material der weiteren Schicht (19) einen ersten Wärmeausdehnungskoeffizienten gemäß der Achse Z aufweist, die Metalllegierung einen zweiten Wärmeausdehnungskoeffizienten gemäß der Achse Z aufweist und wobei der erste Wärmeausdehnungskoeffizient größer ist als der zweite Wärmeausdehnungskoeffizient.

14. Elektronische Leiterplatte (1), die eine mehrschichtige gedruckte Schaltung (2) umfasst, wobei die gedruckte Schaltung (2) mindestens vier leitende Schichten (C₁, C₂, C₃, C₄, C₅, C₆, C₇, C₈) umfasst, die paarweise durch Isolierschichten (10, 11, 12) getrennt sind, wobei:
- eine erste und eine zweite leitende Mantelschicht (C₁, C₂) jeweils auf einer ersten und einer zweiten Isolierschicht (10, 11) befestigt sind, wobei die erste leitende Mantelschicht (C₁) im Wesentlichen eben ist und eine Ebene (X; Y) definiert, die senkrecht zu einer Achse Z verläuft,
- eine erste und eine zweite leitende Innenschicht (C₃, C₄) sich jeweils zwischen der ersten und der zweiten Isolierschicht (10, 11) erstrecken und durch eine dritte Isolierschicht (12) getrennt sind, wobei mindestens die erste leitende Innenschicht (C₃) so behandelt ist, dass mindestens ein Lötbereich (4) gebildet wird,
- eine erste Vertiefung (20) in der ersten leitenden Mantelschicht (C₁) und in der ersten Isolierschicht (10) ausgebildet ist, wobei die erste Vertiefung (20) mindestens teilweise den Lötbereich (4) freilegt, und
ein erstes oberflächenmontiertes elektronisches Bauteil (3) mindestens einen Anschluss (8) umfasst, wobei das erste Bauteil (3) auf der Mantelschicht (C₁) platziert ist, so dass es in Kontakt mit oder in einem Abstand zur ersten leitenden Mantelschicht (C₁) anhand einer Lötnaht (5) steht, wobei der Anschluss (8) des ersten Bauteils (3) anhand der Lötnaht (5) in der ersten Vertiefung (20) befestigt ist.

15. Elektronische Leiterplatte (1) nach Anspruch 14, wobei eine Oberfläche der ersten Vertiefung in der Ebene (X; Y) mindestens gleich 0,04 mm² ist.

16. Elektronische Leiterplatte (1) nach einem der Ansprüche 14 und 15, die so viele erste Vertiefungen (20) umfasst wie das elektronische Bauteil Anschlüsse hat.

17. Elektronische Leiterplatte (1) nach einem der Ansprüche 14 bis 16, wobei die erste Vertiefung (20) eine Metallisierungs-Metallschicht (13) umfasst.

18. Elektronische Leiterplatte (1) nach Anspruch 17, wobei die erste Vertiefung (20) teilweise mit einer Metallisierungs-Metallschicht (13) bedeckt ist.

19. Elektronische Leiterplatte (1) nach einem der Ansprüche 14 bis 18, die ferner eine Lötstoppmaske (17), die auf der ersten leitenden Schicht (C₁) und auf der Oberseite der mindestens teilweise freigelegten Isolierschicht (10) aufgebracht ist und/oder einen Metall-Finish (18) umfasst, das auf der ersten leitenden Mantelschicht (C₁) und den Bereichen der ersten leitenden Innenschicht (C₃) aufgebracht ist, die die erste Vertiefung (20) bilden.

20. Elektronische Leiterplatte (1) nach einem der Ansprüche 14 bis 19, wobei das erste Bauteil (3) einen zusätzlichen Anschluss (8) umfasst, wobei der Anschluss (8) anhand einer Lötnaht (5) auf der ersten leitenden Mantelschicht (C₁) befestigt ist.

21. Elektronische Leiterplatte (1) nach einem der Ansprüche 14 bis 20, wobei die zweite leitende Innenschicht (C₄) so behandelt ist, dass mindestens ein Lötbereich (4) gebildet wird, wobei die elektronische Leiterplatte (1) ferner umfasst:
- eine zweite Vertiefung (20), die in der ersten Isolierschicht (10) und in der dritten Isolierschicht (12) gegenüber der zweiten leitenden Innenschicht (C₄) ausgebildet ist, und
- ein zweites oberflächenmontiertes elektronisches Bauteil (3), das mindestens einen Anschluss (8) umfasst, wobei das zweite Bauteil (3) in Kontakt mit oder in einem Abstand zur ersten leitenden Mantelschicht (C₁) steht, wobei der Anschluss (8) des zweiten Bauteils (3) anhand einer Lötnaht (5) in der zweiten Vertiefung (20) befestigt ist.

22. Elektronische Leiterplatte (1) nach einem der Ansprüche 14 bis 21, wobei das erste Bauteil (3) ferner einen zusätzlichen Anschluss (8) umfasst, die zweite leitende Innenschicht (C₄) so behandelt ist, dass mindestens ein Lötbereich (4) gebildet wird und die elektronische Leiterplatte (1) ferner eine zusätzliche Vertiefung (20) umfasst, die in der ersten Isolierschicht (10) und in der dritten Isolierschicht (12) gegenüber dem Lötbereich (4) der zweiten leitenden Innenschicht (C₄) ausgebildet ist, wobei der zusätzliche Anschluss (8) des Bauteils (3) anhand einer Lötnaht (5) auf dem Lötbereich (4) in der zusätzlichen Vertiefung (20) befestigt ist.

23. Elektronische Leiterplatte (1) nach einem der Ansprüche 14 bis 22, wobei die zweite leitende Innenschicht (C₄) so behandelt ist, dass mindestens ein Lötbereich (4) gebildet wird, wobei die elektronische Leiterplatte (1) ferner umfasst:
- eine vierte Vertiefung (20), die in der zweiten leitenden Mantelschicht (C₂) und in der zweiten Isolierschicht (11) gegenüber der zweiten leitenden Innenschicht (C₄) ausgebildet ist, und
- ein viertes oberflächenmontiertes elektronisches Bauteil (3), das mindestens einen Anschluss (8) umfasst, wobei das vierte Bauteil (3) in Kontakt mit oder in einem Abstand zur zweiten leitenden Mantelschicht (C₂) steht, wobei der Anschluss (8) des vierten Bauteils (3) anhand einer Lötnaht (5) in der vierten Vertiefung (20) befestigt ist.

## Claims

1. A method for manufacturing (S) an electronic board (1), said electronic board (1) comprising a multilayer printed circuit (2), said printed circuit (2) comprising at least four conductive layers (C₁, C₂, C₃, C₄, C₅, C₆, C₇, C₈) separated in pairs by insulating layers (10, 11, 12, 30, 31, 32, 33), including:
- a first and a second conductive skin layer (C₁, C₂) attached on a first and a second insulating layer (10, 11), respectively, the first conductive skin layer (C₁) being substantially planar and defining a plane (X; Y) normal to an axis Z,
- a first and a second inner conductive layer (C₃, C₄), extending between the first and the second insulating layer (10, 11), respectively, and separated by a third insulating layer (12), at least the first inner conductive layer (C₃) being treated so as to form at least one solder pad (4),
the manufacturing method (S) being **characterized in that** it comprises the following steps:
- forming (S1, S4) a first cavity (20) in the first conductive skin layer (C₁) and in the first insulating layer (10), opposite the solder pad (4) of the first inner conductive layer (C₃), so that at least part of the solder pad (4) is exposed,
- filling (S5) the first cavity (20) with a metal alloy accompanied by a solder flux (24),
- placing (S6) a first electronic component (3) in contact with the first conductive skin layer (C₁) opposite the first cavity (20),
- applying a heat treatment (S7) to the printed circuit (2) on which the first component (3) is placed in order to transform the metal alloy accompanied by the solder flux (24) into a solder joint (5) so as to attach the first component (3) to the printed circuit (2).

2. The manufacturing method (S) according to claim 1, wherein the first component (3) comprises at least one terminal and which comprises the formation (S1, S4) of as many first cavities (20) in the first conductive skin layer as the electronic component comprises terminals.

3. The manufacturing method (S) according to one of claims 1 to 2, wherein the first cavity (20) is formed (S1, S4) using at least one of the following techniques: surface photolithography, laser drilling, mechanical drilling, mechanical cutting.

4. The manufacturing method (S) according to one of claims 1 to 3, further comprising a step of metallizing (S2) the first cavity (20) in order to deposit a metal layer (13) in the first cavity (20).

5. The manufacturing method (S) according to claim 5, further comprising an additional step (S3) wherein part of the metal layer (13) of the first cavity (20) is removed prior to the step of filling (S5) the first cavity (20).

6. The manufacturing method (S) according to claim 5, wherein the partial removal (S3) of the metal layer (13) is carried out by laser or by mechanical cutting or by mechanical drilling.

7. The manufacturing method (S) according to one of claims 1 to 6, wherein the first inner conductive layer (C₃) comprises an additional solder pad (4) and the manufacturing method (S) further comprises the following additional steps, prior to the heat treatment step:
- forming (S1, S4) a second cavity (20) in the first insulating layer (10), opposite the additional solder pad (4), so that at least an additional part of the additional solder pad (4) is exposed,
- filling (S5) the second cavity (20) with the metal alloy accompanied by a solder flux (24), and
- placing (S6) a second electronic component (3) opposite the second cavity (20),
the steps of filling (S5) of the first and second cavities (20) and of placing the components (3) being carried out substantially simultaneously.

8. The manufacturing method (S) according to one of claims 1 to 7, further comprising a step of etching the first conductive skin layer (C₁).

9. The manufacturing method (S) according to one of claims 1 to 8, wherein the first cavity (20) is filled in accordance with at least one of the following filling techniques (S5): screen-printing with a screen-printing screen (7), screen-printing without screen-printing screen (7), jetting, passing through a turbulent wave, by soaking or passing through a metal alloy bath in reflow, wave soldering, manual soldering.

10. The manufacturing method (S) according to one of claims 1 to 9, wherein the second inner conductive layer (C₄) is treated so as to form at least one solder pad (4), the manufacturing method (S) further comprising the following steps, prior to the heat treatment step (S7):
- forming (S1, S4) a third cavity (20) in the first insulating layer (10) and in the third insulating layer (12), opposite the solder pad (4) of the second inner conductive layer (C₄), so that at least part of the solder pad (4) of the second inner conductive layer (C₄) is exposed,
- filling (S5) the third cavity (20) with the metal alloy accompanied by a solder flux (24), and
- placing (S6) a third additional electronic component (3) opposite the third cavity (20).

11. The manufacturing method (S) according to one of claims 1 to 10, wherein the second inner conductive layer (C₄) is treated so as to form at least one solder pad (4), the manufacturing method (S) further comprising the following steps, prior to the heat treatment step:
- forming (S1, S4) a fourth cavity (20) in the second conductive skin layer (C₂) and in the second insulating layer (11), opposite the solder pad (4) of the second inner conductive layer (C₄), so that at least part of the solder pad (4) of the second inner conductive layer (C₄) is exposed,
- filling (S5) the fourth cavity (20) with the metal alloy accompanied by a solder flux (24), and
- placing (S6) a fourth electronic component (3) opposite the fourth cavity (20).

12. The method according to one of claims 1 to 11, further comprising, prior to the heat treatment step (S7), a step during which an additional layer (19) comprising an electrically insulating material is applied on the first conductive skin layer (C₁), the first cavity (20) being partly formed in said additional layer (19) and the first component (3) being placed on the additional layer (19).

13. The method according to claim 12, wherein the electrically insulating material of the additional layer (19) has a first coefficient of thermal expansion along the axis Z, the metal alloy has a second coefficient of thermal expansion along the axis Z, and wherein the first coefficient of thermal expansion is greater than the second coefficient of thermal expansion.

14. An electronic board (1) comprising a multilayer printed circuit (2), said printed circuit (2) comprising at least four conductive layers (C₁, C₂, C₃, C₄, C₅, C₆, C₇, C₈) separated in pairs by insulating layers (10, 11, 12), including:
- a first and a second conductive skin layers (C₁, C₂) attached on a first and a second insulating layer (10, 11), respectively, the first conductive layer being substantially planar and defining a plane (X; Y) normal to an axis Z,
- a first and a second inner conductive layers (C₃, C₄), extending between the first and the second insulating layers (10, 11), respectively, and separated by a third insulating layer (12), at least the first inner conductive layer (C₃) being treated so as to form at least one solder pad (4),
- a first cavity (20), formed in the first conductive skin layer (C₁) and in the first insulating layer (10), said first cavity (20) exposing at least partly the solder pad (4), and
- a first surface-mounted electronic component (3) comprising at least one terminal (8), said first component (3) being placed on the first conductive skin layer (C₁) so as to be in contact or at a distance from the first conductive skin layer (C₁) by means of a solder joint (5), the terminal (8) of the first component (3) being attached into the first cavity (20) by means of the solder joint (5).

15. The electronic board (1) according to claim 14, wherein an area of the first cavity, in the plane (X; Y), is at least equal to 0.04 mm².

16. The electronic board (1) according to one of claims 14 and 15, comprising as many first cavities (20) as the electronic component has terminals.

17. The electronic board (1) according to one of claims 14 to 16, wherein the first cavity (20) comprises a metal layer (13) of metallization.

18. The electronic board (1) according to claim 17, wherein the first cavity (20) is partially covered by a metal layer (13) of metallization.

19. The electronic board (1) according to one of claims 14 to 18, further comprising a solder mask (17) applied on the first conductive layer (C₁) and on top of the insulating layer (10) which is at least partially exposed and/or a metallic finish (18) applied on the first conductive skin layer (C₁) and the areas of the first inner conductive layer (C₃) which form the first cavity (20).

20. The electronic board (1) according to one of claims 14 to 19, wherein the first component (3) comprises an additional terminal (8), said terminal (8) being attached on the first conductive skin layer (C₁) by means of a solder joint (5).

21. The electronic board (1) according to one of claims 14 to 20, wherein the second inner conductive layer (C₄) is treated so as to form at least one solder pad (4), the electronic board (1) further comprising:
- a second cavity (20), formed in the first insulating layer (10) and in the third insulating layer (12), opposite the second inner conductive layer (C₄), and
- a second surface-mounted electronic component (3) comprising at least one terminal (8), said second component (3) being in contact or at a distance from the first conductive skin layer (C₁), the terminal (8) of the second component (3) being attached into the second cavity (20) by means of a solder joint (5).

22. The electronic board (1) according to one of claims 14 to 21, wherein the first component (3) further comprises an additional terminal (8), the second inner conductive layer (C₄) is treated so as to form at least one solder pad (4) and the electronic board (1) further comprises an additional cavity (20), formed in the first insulating layer (10) and in the third insulating layer (12), opposite the solder pad (4) of the second inner conductive layer (C₄), the additional terminal (8) of the component (3) being attached on said solder pad (4) in the additional cavity (20) by means of a solder joint (5).

23. The electronic board (1) according to one of claims 14 to 22, wherein the second inner conductive layer (C₄) is treated so as to form at least one solder pad (4), the electronic board (1) further comprising:
- a fourth cavity (20), formed in the second conductive skin layer (C₂) and in the second insulating layer (11), opposite the second inner conductive layer (C₄), and
- a fourth surface-mounted electronic component (3) comprising at least one terminal (8), said fourth component (3) being in contact or at a distance from the second conductive skin layer (C₂), the terminal (8) of the fourth component (3) being attached into the fourth cavity (20) by means of a solder joint (5).
